# EUROPEAN PATENT APPLICATION

(11) **EP 4 811 654 A1**
(43) Date of publication of application: **23.09.2026**
(21) Application number: 25217947.8
(22) Date of filing: 24.11.2025
(51) Int. Cl.: H03F 1/30, H03F 3/217, H03F 3/24, H03F 3/72, H03M 1/06, H03M 1/66, H03F 3/195

(54) **RADIO FREQUENCY COMMUNICATION CIRCUITS AND METHODS**

(30) Priority: 21.03.2025 US 202519086207
(71) Applicant: INTEL Corporation, Santa Clara, CA 95054 (US)
(72) Inventor: DEGANI, Ofir, 22801 Nes-Ammin (IL); ZOHAR, Limor, Tel Aviv (IL); EILAT, Yishai, 36005 Alonei Aba (IL); ROZENFELD, Yuri, 3542003 Haifa (IL); AHN, Woojin, Folsom (US)
(74) Representative: Viering, Jentschura & Partner mbB Patent- und Rechtsanwälte

(57) **Abstract**

An apparatus may include a digital power amplifier (DPA) comprising a plurality of amplifier cells configured to provide an output signal based on amplitude control information, wherein each amplifier cell is switchable to contribute to the output signal; and a controller configured to enable a subset of the plurality of amplifier cells according to an activation sequence, wherein the subset includes enabled amplifier cells arranged non-adjacently, with at least one inactive amplifier cell of the plurality of amplifier cells positioned between adjacent enabled amplifier cells.

## Description

### Background

In radio communication networks in accordance with many radio communication technologies, such as wireless local area network (WLAN or Wi-Fi), Bluetooth, fourth generation long term evolution (LTE), and fifth generation (5G) new radio (NR), various methods are employed to provide wireless data transfer with desired efficiency, speed, and reliability. These networks require robust design and implementation of radio frequency (RF) components to achieve desired performance characteristics, including low power consumption, high bandwidth, and minimal interference. As wireless communication technologies evolve to meet the growing demand for data and mobile applications, the need for efficient and scalable RF solutions may have become critical.

The digital transmit (DTX) architecture represents a paradigm shift from traditional analog transmit architectures, offering enhanced integration and efficiency in wireless communication systems. Digital transmit architectures leverage digital signal processing techniques, enabling compact designs and scalability in advanced complementary metal-oxide semiconductor (CMOS) processes, addressing the escalating demands for wider bandwidths and higher modulation schemes. Unlike analog transmit architectures, such as quadrature analog transmit (Q-ATX) systems, which utilize class-AB CMOS power amplifiers (PAs) and quadrature modulation, digital transmit architectures rely on digital signal manipulation, enabling improved power efficiency through switching power amplifiers and compact die area. Many digital transmit architectures, such as the digital polar transmitter (DPTX) architecture, may include two primary functional blocks: A digital-to-time converter (DTC) and a digital power amplifier (DPA). The digital-to-time converter may utilize phase information to modulate a local oscillator (LO) signal, while the digital power amplifier may modulate the amplitude of the signal onto the phase-modulated LO (MOLO) signal to generate a radio frequency (RF) communication signal.

### Brief Description of the Drawings

In the drawings, like reference characters generally refer to the same parts throughout the different views. The drawings are not necessarily to scale, emphasis instead generally being placed upon illustrating the principles described herein. In the following description, various aspects are described with reference to the following drawings, in which:
FIGs. 1 and 2 depict a general network and device architecture for wireless communications and/or sensing operations;
FIG. 3 shows an exemplary illustration of various communication elements of an apparatus for a wireless communication device;
FIG. 4 shows an exemplary illustration of a transmit path of an RF transceiver;
FIG. 5 illustrates a block diagram of an example of a communication circuitry;
FIG. 6 shows an illustrative example of a digital power amplifier cell;
FIG. 7 shows an illustrative example of a digital power amplifier operation;
FIG. 8 shows an illustrative example of a digital power amplifier operation;
FIG. 9 shows an illustrative example of a digital power amplifier operation;
FIG. 10 illustrates an example of a complementary cumulative distribution function in accordance with various aspects described herein;
FIG. 11 shows an example of a method.

### Description

The following detailed description refers to the accompanying drawings that show, by way of illustration, exemplary details, and aspects in which aspects described herein may be practiced.

The transmission architectures have been transformed into distinct RF transmitter designs including the digital transmitter architectures. These architectures can leverage digital signal processing for enhanced efficiency and scalability. Unlike traditional analog transmitters, which may rely on quadrature modulation and analog power amplifiers, digital polar transmitters may utilize components such as digital-to-time converters and digital power amplifiers. These components can enable precise modulation of phase and amplitude, which may make them particularly suitable for wideband applications with stringent performance requirements.

Wireless communication systems rely on efficient signal transmission and amplification to ensure high performance, reliability, and cost-effectiveness. As devices become more compact and power-efficient, the demand for optimized digital power amplifiers has grown significantly. Digital power amplifiers play a crucial role in wireless transmitters by amplifying signals while maintaining signal integrity and efficiency. Given the widespread deployment of wireless technologies in mobile devices, base stations, and Internet-of-Things (IoT) applications, there is a continuous need for improving digital power amplifier performance while addressing fundamental challenges such as heat dissipation, power efficiency, and component longevity.

A challenge in the design of digital power amplifiers may include managing the heat generated during operation. Semiconductor devices, including digital power amplifiers, produce heat as a byproduct of electrical switching and power amplification. If this heat is not effectively dissipated, it can accumulate within the device, leading to increased operating temperatures. Elevated temperatures, in turn, contribute to performance degradation, reduced efficiency, and accelerated aging of semiconductor components. These effects can ultimately impact the reliability and lifespan of the amplifier, making thermal management a key consideration in digital power amplifier design. In high-performance wireless applications, maintaining thermal stability is critical, as excessive heat may cause signal distortion, variations in output power, and eventual device failure.

There have been various approaches to mitigate heat dissipation challenges in digital power amplifiers. One conventional approach involves reducing the density of circuit components, thereby allowing for better thermal dissipation. However, decreasing circuit density comes at the cost of increased chip area and manufacturing expenses, making it an impractical solution for cost-sensitive applications. Another approach can rely on external thermal management solutions such as heatsinks, fans, or dedicated cooling systems. While effective in controlling temperatures, these solutions introduce additional costs, increase system complexity, and may not be suitable for compact and integrated wireless devices.

A strategy for improving digital power amplifier longevity can include operating the amplifier at reduced power levels and avoiding conditions where excessive heat buildup occurs. By limiting the maximum operating power, the thermal stress on the device can be reduced, thereby extending its operational lifetime. However, this method can sacrifice overall performance, as reducing the amplifier's output power directly impacts signal strength and transmission efficiency. In competitive wireless applications, where high power efficiency and signal integrity are desired, such trade-offs may be deemed undesirable.

Correspondingly, there remains a need for an approach that enhances the thermal performance and reliability of digital power amplifiers without compromising power efficiency, chip size, or overall performance. Aspects described herein address these challenges by introducing a configuration that optimally distributes heat dissipation across the digital power amplifier. Rather than relying on external cooling systems or reducing circuit density, aspects described herein may employ an advanced control mechanism that dynamically selects and activates amplifier cells in a manner that reduces or minimizes localized heat accumulation.

A digital power amplifier may typically include an array or multiple arrays of amplifier cells, each of which contributes to the overall output signal. Aspects described herein may include an activation scheme that enables only a subset of the amplifier cells at a given time while ensuring that the enabled cells are distributed in a non-adjacent manner. By positioning at least one inactive amplifier cell between adjacent enabled cells, aspects described herein may effectively spread the heat dissipation over a larger area, reducing peak silicon temperatures, particularly when desired power levels (e.g. indicated by amplitude control information) that are lower than the power level capacity of the digital power amplifier. This approach can address a fundamental design limitation in conventional digital power amplifiers, where clusters of active cells generate concentrated thermal hotspots, leading to uneven heating and localized performance degradation.

Further, aspects described herein can enhance the lifetime of the digital power amplifier by incorporating multiple predefined activation sequences. These sequences can allow for adaptive operation, where the distribution of active cells can be dynamically adjusted based on operating conditions. By alternating between different activation sequences, the wear on individual amplifier cells may be distributed more evenly, mitigating long-term degradation effects. This technique may provide significant improvements in device longevity while maintaining optimal performance under varying load conditions.

Through aspects described herein, benefits may be extended beyond thermal management and reliability. Through some of the aspects, a highly efficient configuration that does not compromise power consumption, signal quality, or chip size, may be facilitated. Unlike prior solutions that require additional cooling components or trade-offs in performance, aspects described herein leverage an intrinsic operational strategy to optimize thermal dissipation. The ability to dynamically adjust activation patterns based on real-time feedback, such as amplitude control information or thermal measurements, may further enhance adaptability and efficiency.

Aspects described herein may include an apparatus including a digital power amplifier with a plurality of switchable amplifier cells and a control circuit that may enable a subset of these cells according to an activation sequence. The activation sequence can ensure that enabled amplifier cells are arranged in a non-adjacent manner, with at least one inactive amplifier cell positioned between adjacent enabled cells, especially when the desired output level is below a certain amplitude. This spatial distribution may mitigate localized heat accumulation, thereby reducing thermal stress and enhancing the reliability and longevity of the amplifier.

In some aspects, the apparatus may incorporate multiple activation sequences, each representing a distinct pattern for selectively enabling amplifier cells. By storing and dynamically selecting from a plurality of activation sequences, the apparatus may allow for adaptive operation based on operating conditions, such as thermal feedback from temperature sensors or amplitude control information. This dynamic adjustment can ensure optimal performance under varying thermal and power conditions, thereby preventing excessive heating in any specific region of the amplifier array.

In some aspects, the arrangement of amplifier cells may be facilitated in a two-dimensional matrix, which can further contribute to efficient thermal distribution. Activation sequences may be defined in respective configurations where enabled amplifier cells are distributed across specific rows or columns, ensuring a structured pattern that enhances heat dissipation. Additionally, activation sequences may be designed to achieve a uniform distribution of enabled cells, ensuring a balanced thermal profile and preventing localized performance degradation.

Beyond thermal management, the apparatus may ensure that the number of enabled amplifier cells directly corresponds to the desired output power level at the output of the digital power amplifier. The control circuit may determine which amplifier cells are to be enabled based on amplitude control information, and switching signals may be generated accordingly. By ensuring that only the enabled amplifier cells contribute to the output signal, the apparatus can improve power efficiency while maintaining signal integrity. Furthermore, the inclusion of a digital-to-time converter and a processor providing amplitude and phase control information may facilitate seamless integration into advanced communication systems, as in digital transmission architectures, enabling high-performance wireless transmission with precise power and phase modulation control.

As described herein, a digital-to-time converter may include a circuit structure including a first node configured for signal processing, a second node configured to receive a reference signal, a digital-to-analog signal converter section configured to process digital control words, a configurable impedance network selectively coupled to the first node, a switching circuit arrangement having a first switch coupled to the reference signal and a second switch coupled to a reset voltage level, a comparator circuit coupled to an output stage, a capacitive element configured for timing control, and a current source configured for edge timing control, wherein the described structure is configured to receive digital control words representing desired phase modulation parameters, process a reference clock signal from a local oscillator, convert the digital input code into corresponding time delays, generate timing-adjusted output signals with controlled edge transitions, and provide phase-modulated output suitable for driving RF stages, such that the structure performs time-domain conversion of digital input signals into precisely controlled timing variations of an output signal.

A digital power amplifier may include a circuit structure including switching elements arranged for RF signal amplification. Common implementations may include RF-DAC (RF-digital to analog converter)configurations, which may utilize switched capacitor arrays with binary-weighted capacitors and digital control logic for capacitor switching, and/or switched capacitor power amplifier (SCPA) implementations featuring H-bridge configurations of semiconductor switches coupled with capacitor arrays for charge-domain signal processing and digital decoder/encoder blocks for switch control. Additional structural variants may include class-G implementations with dual power supply voltages, quadrature switched capacitor power amplifier structures that combine in-phase/quadrature-phase (I/Q) signals on shared capacitor arrays, digital polar architectures incorporating envelope and phase processing, and Doherty configurations utilizing carrier and peaking amplifiers. These structures may typically incorporate protection circuits and may be integrated with digital control circuitry implemented in field programmable gate array (FPGA) or dedicated silicon for enhanced functionality and control.

The apparatuses and methods described herein may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a global system for mobile communications ("GSM") radio communication technology, a general packet radio service ("GPRS") radio communication technology, an enhanced data rates for GSM evolution ("EDGE") radio communication technology, and/or a third generation partnership project ("3GPP") radio communication technology, for example universal mobile telecommunications system ("UMTS"), freedom of multimedia access ("FOMA"), 3GPP long term evolution ("LTE"), 3GPP long term evolution advanced ("LTE Advanced"), code division multiple access 2000 ("CDMA2000"), cellular digital packet data ("CDPD"), mobitex, third generation (3G), circuit switched data ("CSD"), high-speed circuit-switched data ("HSCSD"), universal mobile telecommunications system ("Third Generation") ("UMTS (3G)"), wideband code division multiple access (universal mobile telecommunications system) ("W-CDMA (UMTS)"), high speed packet access ("HSPA"), high-speed downlink packet access ("HSDPA"), high-speed uplink packet access ("HSUPA"), high speed packet access plus ("HSPA+"), universal mobile telecommunications system-time-division duplex ("UMTS-TDD"), time division-code division multiple access ("TD-CDMA"), time division-synchronous code division multiple access ("TD-CDMA"), 3rd generation partnership project release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10) , 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 4G, 3GPP LTE Extra, LTE-Advanced Pro, LTE Licensed-Assisted Access ("LAA"), MuLTEfire, UMTS Terrestrial Radio Access ("UTRA"), evolved UMTS terrestrial radio access ("E-UTRA"), long term evolution advanced (4th Generation) ("LTE Advanced (4G)"), cdmaOne ("2G"), code division multiple access 2000 (Third generation) ("CDMA2000 (3G)"), evolution-data optimized or evolution-data only ("EV-DO"), advanced mobile phone system (1st Generation) ("AMPS (1G)"), total access communication arrangement/extended total access communication arrangement ("TACS/ETACS"), digital AMPS (2nd Generation) ("DAMPS (2G)"), push-to-talk ("PTT"), mobile telephone system ("MTS"), improved mobile telephone system ("IMTS"), advanced mobile telephone system ("AMTS"), OLT (Norwegian for offentlig landmobil telefoni, public land mobile telephony), MTD (Swedish abbreviation for Mobiltelefonisystem D, or Mobile telephony system D), public automated land mobile ("Autotel/PALM"), ARP (Finnish for Autoradiopuhelin, "car radio phone"), NMT (Nordic Mobile Telephony), high capacity version of NTT (Nippon Telegraph and Telephone) ("Hicap"), cellular digital packet data ("CDPD"), Mobitex, DataTAC, integrated digital enhanced network ("iDEN"), personal digital cellular ("PDC"), circuit switched data ("CSD"), personal handy-phone system ("PHS"), wideband integrated digital enhanced network ("WiDEN"), iBurst, unlicensed mobile access ("UMA"), also referred to as also referred to as 3GPP generic access network, or GAN standard), Zigbee, Bluetooth^{®}, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.11p and other) vehicle-to-vehicle ("V2V") and vehicle-to-x ("V2X") and vehicle-to-infrastructure ("V2I") and infrastructure-to-vehicle ("I2V") communication technologies, 3GPP cellular V2X, DSRC (dedicated short-range communications) communication arrangements such as intelligent-transport-systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = licensed shared access in 2.3-2.4 GHz, 3.4-3.6 GHz, 3.6-3.8 GHz and further frequencies and SAS = spectrum access system in 3.55-3.7 GHz and further frequencies), and may use various spectrum bands including, but not limited to, IMT (international mobile telecommunications) spectrum (including 450-470 MHz, 690-960 MHz, 1710-2025 MHz, 2110-2200 MHz, 2300-2400 MHz, 2500-2690 MHz, 698-790 MHz, 610-790 MHz, 3400-3600 MHz, etc., where some bands may be limited to specific region(s) and/or countries), IMT-advanced spectrum, IMT-2020 spectrum (expected to include 3600-3800 MHz, 3.5 GHz bands, 600 MHz bands, bands within the 24.25-86 GHz range, etc.), spectrum made available under FCC's "Spectrum Frontier" 4G initiative (including 27.5-28.35 GHz, 29.1-29.25 GHz, 31-31.3 GHz, 37-38.6 GHz, 38.6-40 GHz, 42-42.5 GHz, 47-64 GHz, 64-71 GHz, 61-76 GHz, 81-86 GHz and 92-94 GHz, etc.), the ITS (Intelligent Transport Systems) band of 4.9 GHz (typically 4.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 60.2 GHz-71 GHz band, any band between 65.88 GHz and 61 GHz, bands currently allocated to automotive radar applications such as 66-81 GHz, and future bands including 94-300 GHz and above. Furthermore, the apparatuses and methods described herein can also employ radio communication technologies on a secondary basis on bands such as the TV white space bands (typically below 690 MHz) where e.g. the 400 MHz and 600 MHz bands are prospective candidates. Besides cellular applications, specific applications for vertical markets may be addressed such as PMSE (program making and special events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on prioritized access to the spectrum e.g., with highest priority to tier-1 users, followed by tier-2, then tier-3, etc. users, etc. The apparatuses and methods described herein can also use radio communication technologies with different single carrier or OFDM flavors (CP-OFDM, SC-FDMA, SC-OFDM, filter bank-based multicarrier (FBMC), OFDMA, etc.) and e.g. 3GPP NR (New Radio), which can include allocating the OFDM carrier data bit vectors to the corresponding symbol resources.

Radio communication technologies described herein may be classified as one of short-range radio communication technology or cellular-wide area radio communication technology. Short-range radio communication technologies may include Bluetooth, WLAN (e.g., according to any IEEE 802.11 standard), and other similar radio communication technologies. Cellular Wide Area radio communication technologies may include global system for mobile communications ("GSM"), code division multiple access 2000 ("CDMA2000"), universal mobile telecommunications system ("UMTS"), long term evolution ("LTE"), general packet radio service ("GPRS"), evolution-data optimized ("EV-DO"), enhanced data rates for GSM evolution ("EDGE"), high speed packet access (HSPA; including high speed downlink packet access ("HSDPA"), high speed uplink packet access ("HSUPA"), HSDPA Plus ("HSDPA+"), and HSUPA Plus ("HSUPA+")), worldwide interoperability for microwave access ("WiMax") (e.g., according to an IEEE 802.16 radio communication standard, e.g., WiMax fixed or WiMax mobile), etc., and other similar radio communication technologies. Cellular wide area radio communication technologies also include "small cells" of such technologies, such as microcells, femtocells, and picocells. Cellular wide area radio communication technologies may be generally referred to herein as "cellular" communication technologies.

In the context of WLAN, the apparatuses and methods described herein may be for various wireless devices, including access points (APs) and wireless station devices (STAs), each may be equipped with RF communication capabilities. These devices may incorporate transmission and reception components designed to handle RF signals within specified bandwidths and channels as described herein. The communication components typically include both hardware elements and software implementations for signal processing, enabling modulation and demodulation according to specified communication protocols. These devices may particularly be configured to operate under various wireless communication standards, including those developed by the Institute of Electrical and Electronics Engineers (IEEE) for Wi-Fi applications. The RF components, working in conjunction with antenna systems, enable communication across multiple frequency bands. These frequency bands may include, among others, the 2.4 GHz band supporting protocols such as IEEE 802.11b/g/n/ax, the 5 GHz band supporting IEEE 802.11n/ac/ax/be, and the 6 GHz band supporting newer standards like IEEE 802.11ax/be. Additional operational frequencies may extend to 60 GHz (supporting IEEE 802.11ad/ay) and 800 MHz (supporting IEEE 802.11ah), with antenna systems capable of operating at frequencies such as 28 GHz and 40 GHz. Beyond these specified standards, the devices may support emerging Wi-Fi protocols and alternative wireless communication technologies. These alternatives may include, but are not limited to, Bluetooth technology, dedicated short-range communication systems, Ultra-High Frequency applications (including IEEE 802.11af and IEEE 802.22), and white band frequency utilization. The RF reception chain may typically incorporate essential components such as low-noise amplifiers, signal amplification stages, analog-to-digital conversion systems, data buffering mechanisms, and digital baseband processing units, all configured to ensure effective wireless communication capabilities.

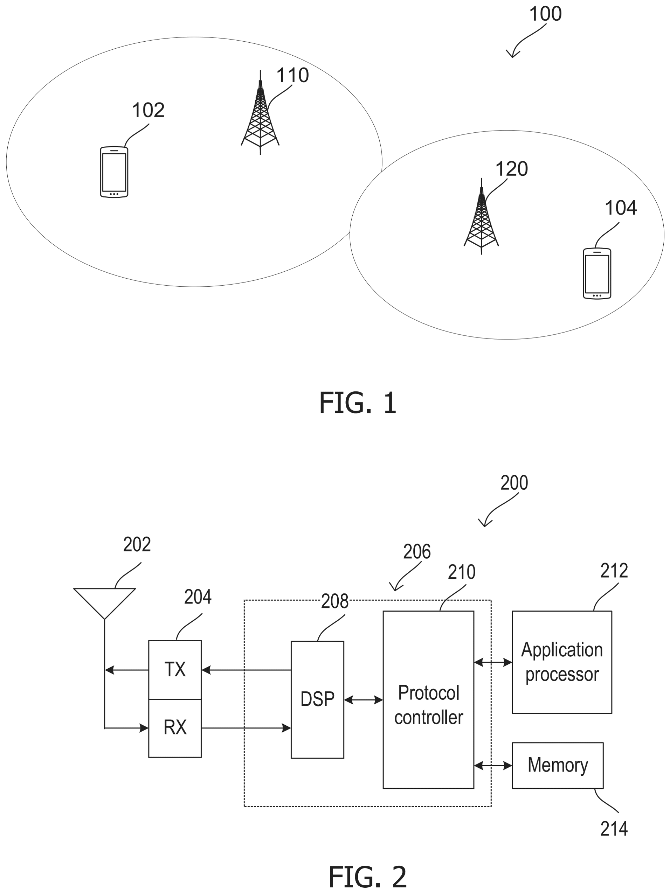

FIGs. 1 and 2 depict a general network and device architecture for wireless communications and/or sensing operations. In particular, FIG. 1 shows exemplary radio communication network 100 according to some aspects, which may include terminal devices 102 and 104 and network access nodes 110 and 120 (e.g. radio access nodes). Radio communication network 100 may communicate with terminal devices 102 and 104 via network access nodes 110 and 120 over a radio access network. Each of terminal devices 102 and 104 or network access nodes 110 and 120 may be a sensing communication device as described herein that may perform a sensing operation. Although certain examples described herein may refer to a particular radio access network context (e.g., 6G, 5G NR, LTE, UMTS, GSM, other 3rd Generation Partnership Project (3GPP) networks, WLAN/WiFi, Bluetooth, millimeter wave, etc.), these examples are demonstrative and may therefore be readily applied to any other type or configuration of a radio access network. The number of network access nodes and terminal devices in radio communication network 100 is exemplary and is scalable to any amount.

In an exemplary cellular context, network access nodes 110 and 120 may be base stations (e.g., eNodeBs, NodeBs, Base Transceiver Stations (BTSs), gNodeBs, or any other type of base station), while terminal devices 102 and 104 may be cellular terminal devices (e.g., Mobile Stations (MSs), User Equipments (UEs), or any type of cellular terminal device). Network access nodes 110 and 120 may therefore interface (e.g., via backhaul interfaces) with a cellular core network such as an Evolved Packet Core (EPC, for LTE), Core Network (CN, for UMTS), or other cellular core networks, which may also be considered part of radio communication network 100. The cellular core network may interface with one or more external data networks. In an exemplary short-range context, network access nodes 110 and 120 may be access points (APs, e.g., WLAN or WiFi APs), while terminal devices 102 and 104 may be short-range terminal devices (e.g., stations (STAs)). Network access nodes 110 and 120 may interface (e.g., via an internal or external router) with one or more external data networks. Network access nodes 110 and 120 and terminal devices 102 and 104 may include one or multiple transmission/reception points (TRPs).

Network access nodes 110 and 120 (and, optionally, other network access nodes of radio communication network 100 not explicitly shown in FIG. 1) may accordingly provide a radio access network to terminal devices 102 and 104 (and, optionally, other terminal devices of radio communication network 100 not explicitly shown in FIG. 1). In an exemplary cellular context, the radio access network provided by network access nodes 110 and 120 may enable terminal devices 102 and 104 to wirelessly access the core network via radio communications. The core network may provide switching, routing, and transmission, for traffic data related to terminal devices 102 and 104, and may further provide access to various internal data networks (e.g., control nodes, routing nodes that transfer information between other terminal devices on radio communication network 100, etc.) and external data networks (e.g., data networks providing voice, text, multimedia (audio, video, image), and other Internet and application data). Furthermore, terminal devices 102 and 104 and network access nodes 110 and 120 may perform a sensing operation, particularly radar sensing, in accordance with JCAS architecture. In an exemplary short-range context, the radio access network provided by network access nodes 110 and 120 may provide access to internal data networks (e.g., for transferring data between terminal devices connected to radio communication network 100) and external data networks (e.g., data networks providing voice, text, multimedia (audio, video, image), and other Internet and application data).

In accordance with various aspects described herein, network access nodes 110 and 120 and terminal devices 102 and 104 can perform their respective sensing operations in a manner, such that each device may perform its respective sensing operation according to its respective sensing signal configuration. Accordingly, each of these devices may generate and transmit its respective sensing signals according to a respective configuration that may include at least one of the frequency resources used to transmit sensing signals, the bandwidth of the sensing signals, the transmit power of the sensing signals, and waveform shape of the sensing signals which the respective device may determine before generating and/or transmitting the sensing signals. In some examples, a central orchestrator (e.g. a sensing orchestrator) may determine a respective sensing signal configuration for each device and send information representing the respective sensing signal configuration to the respective device.

The radio access network and core network (if applicable, such as for a cellular context) of radio communication network 100 may be governed by communication protocols that can vary depending on the specifics of radio communication network 100. Such communication protocols may define the scheduling, formatting, and routing of both user and control data traffic through radio communication network 100, which includes the transmission and reception of such data through both the radio access and core network domains of radio communication network 100. Accordingly, terminal devices 102 and 104 and network access nodes 110 and 120 may follow the defined communication protocols to transmit and receive data over the radio access network domain of radio communication network 100, while the core network may follow the defined communication protocols to route data within and outside of the core network. Exemplary communication protocols include 6G, 5G NR, LTE, UMTS, GSM, WiMAX, Bluetooth, WiFi, mmWave, etc., any of which may be applicable to radio communication network 100.

FIG. 2 shows an exemplary internal configuration of a communication device (e.g. a sensing communication device) according to various aspects described herein. The communication device may include various aspects of radio communication devices (e.g. network access nodes 110, 120) or various aspects of mobile radio communication devices (e.g. terminal device 102, 104) as well. The communication device 200 may include antenna system 202, radio frequency (RF) transceiver 204, baseband modem 206 (including digital signal processor 208 and protocol controller 210), application processor 212, and memory 214. Although not explicitly shown in FIG. 2, in some aspects communication device 200 may include one or more additional hardware and/or software components, such as processors/microprocessors, controllers/microcontrollers, other specialty or generic hardware/processors/circuits, peripheral device(s), memory, power supply, external device interface(s), subscriber identity module(s) (SIMs), user input/output devices (display(s), keypad(s), touchscreen(s), speaker(s), external button(s), camera(s), microphone(s), etc.), or other related components.

Communication device 200 may transmit and receive radio signals on one or more radio access networks. Baseband modem 206 may direct such communication functionality of communication device 200 according to the communication protocols associated with each radio access network and may execute control over antenna system 202 and RF transceiver 204 to transmit and receive radio signals according to the formatting and scheduling parameters defined by each communication protocol. Although various practical designs may include separate communication components for each supported radio communication technology (e.g., a separate antenna, RF transceiver, digital signal processor, and controller), for purposes of conciseness the configuration of communication device 200 shown in FIG. 2 depicts only a single instance of such components.

Communication device 200 may transmit and receive wireless signals with antenna system 202. Antenna system 202 may be a single antenna or may include one or more antenna arrays that each include multiple antenna elements. For example, antenna system 202 may include an antenna array at the top of communication device 200 and a second antenna array at the bottom of communication device 200. In some aspects, antenna system 202 may additionally include analog antenna combination and/or beamforming circuitry. In the receive (RX) path, RF transceiver 204 may receive analog radio frequency signals from antenna system 202 and perform analog and digital RF front-end processing on the analog radio frequency signals to produce digital baseband samples (e.g., in-phase/quadrature (IQ) samples) to provide to baseband modem 206. RF transceiver 204 may include analog and digital reception components including amplifiers (e.g., low noise amplifiers (LNAs)), filters, RF demodulators (e.g., RF IQ demodulators), and analog-to-digital converters (ADCs), which RF transceiver 204 may utilize to convert the received radio frequency signals to digital baseband samples.

In the transmit (TX) path, RF transceiver 204 may receive digital baseband samples from baseband modem 206 and perform analog and digital RF front-end processing on the digital baseband samples to produce analog radio frequency signals to provide to antenna system 202 for wireless transmission. RF transceiver 204 may thus include analog and digital transmission components including amplifiers (e.g., power amplifiers (PAs), filters, RF modulators (e.g., RF IQ modulators), and digital-to-analog converters (DACs), which RF transceiver 204 may utilize to mix the digital baseband samples received from baseband modem 206 and produce the analog radio frequency signals for wireless transmission by antenna system 202. In some aspects, baseband modem 206 may control the radio transmission and reception of RF transceiver 204, including specifying the transmit and receive radio frequencies for the operation of RF transceiver 204.

In accordance with various aspects provided herein, the communication device 200 may perform sensing operations within the radio communication network 100. Illustratively, the baseband modem 206 (e.g. the digital signal processor 208) may be configured to perform sensing-related signal processing in addition to traditional communication processing. For example, the baseband modem 206 may be configured to implement techniques like radar waveform generation, matched filtering for target detection, parameter estimation (e.g., range, velocity, angle) of detected targets, and environmental mapping. In some examples, the baseband modem 206 (e.g. the digital signal processor 208) may use its hardware accelerators and parallel processing capabilities to efficiently handle the computationally intensive sensing algorithms alongside communication tasks.

Furthermore, the baseband modem 206 (e.g. the protocol controller 210) may be configured to coordinate and/or manage joint operation of communication and sensing functions. Illustratively, the baseband modem 206 may schedule sensing and communication operations, allocate resources (e.g., time/frequency resources, antenna beams) between the sensing operations and the communication operations, and manage interference between them. The baseband modem (e.g. the protocol controller 210) may further implement sensing control protocols and interfaces to enable coordination with other network entities for distributed sensing operations as described herein.

In some examples, the application processor 212 may be configured to act as a source and sink for sensing data, similar to its role for communication data. The application processor 212 may execute sensing applications that are configured to process and interpret the sensing data received from the baseband modem 206. Illustratively, the application processor 212 may perform at least one object detection and tracking, environmental mapping, and/or situational awareness services using the sensing data. In some examples, the application processor 212 may interface with external sensors (e.g., cameras, lidars) to fuse data from multiple sensing modalities for enhanced perception capabilities.

Correspondingly, the RF transceiver 204 may further support the transmission and reception of sensing waveforms in addition to communication signals. Illustratively, the RF transceiver 204 may generate and transmit sensing signals (e.g., frequency-modulated continuous waveforms for radar), and may process the received sensing signals to extract target information. In some examples, the RF transceiver 204 can use the same analog and digital components (e.g., amplifiers, filters, modulators/demodulators, ADCs/DACs) for sensing operations and communication operations, potentially with additional hardware accelerators for sensing-specific tasks. Illustratively, the antenna system 202 may also support both communication and sensing functions, in some examples with separate antenna arrays or shared arrays with beamforming capabilities. In accordance with various aspects, the antenna system 202 can form narrow beams for extended sensing range or wide beams for faster coverage, depending on the sensing requirements and resource constraints. Techniques like MIMO and beamforming can be employed to enhance the sensing performance and enable features like high-resolution target parameter estimation and interference mitigation.

As shown in FIG. 2, baseband modem 206 may include digital signal processor 208, which may perform physical layer (PHY, layer 1) transmission and reception processing to, in the transmit path, prepare outgoing transmit data provided by protocol controller 210 for transmission via RF transceiver 204, and, in the receive path, prepare incoming received data provided by RF transceiver 204 for processing by protocol controller 210. Digital signal processor 208 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancelation, and any other physical layer processing functions. Digital signal processor 208 may be structurally realized as hardware components (e.g., as one or more digitally-configured hardware circuits or field programmable gate arrays (FPGAs)), software-defined components (e.g., one or more processors configured to execute program code defining arithmetic, control, and I/O instructions (e.g., software and/or firmware) stored in a non-transitory computer-readable storage medium), or as a combination of hardware and software components. In some aspects, digital signal processor 208 may include one or more processors configured to retrieve and execute program code that defines control and processing logic for physical layer processing operations. In some aspects, digital signal processor 208 may execute processing functions with software via the execution of executable instructions. In some aspects, digital signal processor 208 may include one or more dedicated hardware circuits (e.g., application-specific integrated circuits (ASICs), field programmable gate arrays, and other hardware) that are digitally configured to specific execute processing functions, where one or more processors of digital signal processor 208 may offload certain processing tasks to these dedicated hardware circuits, which are known as hardware accelerators. Exemplary hardware accelerators can include fast Fourier transform (FFT) circuits and encoder/decoder circuits. In some aspects, the processor and hardware accelerator components of digital signal processor 208 may be realized as a coupled integrated circuit.

Communication device 200 may be configured to operate according to one or more radio communication technologies. Digital signal processor 208 may be responsible for lower-layer processing functions (e.g., layer 1/PHY) of the radio communication technologies, while protocol controller 210 may be responsible for upper-layer protocol stack functions (e.g., data link layer/layer 2 and/or network layer/layer 3). Protocol controller 210 may thus be responsible for controlling the radio communication components of the communication device 200 (antenna system 202, RF transceiver 204, and digital signal processor 208) in accordance with the communication protocols of each supported radio communication technology, and accordingly may represent the access stratum (AS) and non-access stratum (NAS) (also encompassing layer 2 and layer 3) of each supported radio communication technology. Protocol controller 210 may be structurally embodied as a protocol processor configured to execute protocol stack software (retrieved from a controller memory) and subsequently control the radio communication components of communication device 200 to transmit and receive communication signals in accordance with the corresponding protocol stack control logic defined in the protocol software. Protocol controller 210 may include one or more processors configured to retrieve and execute program code that defines the upper-layer protocol stack logic for one or more radio communication technologies, which can include data link layer/layer 2 and network layer/layer 3 functions. Protocol controller 210 may be configured to perform both user-plane and control-plane functions to facilitate the transfer of application layer data to and from radio communication device 200 according to the specific protocols of the supported radio communication technology. User-plane functions can include header compression and encapsulation, security, error checking and correction, channel multiplexing, scheduling, and priority, while control-plane functions may include setup and maintenance of radio bearers. The program code retrieved and executed by protocol controller 210 may include executable instructions that define the logic of such functions.

Communication device 200 may also include application processor 212 and memory 214. Application processor 212 may be a CPU, and may be configured to handle the layers above the protocol stack, including the transport and application layers. Application processor 212 may be configured to execute various applications and/or programs of communication device 200 at an application layer of communication device 200, such as an operating system (OS), a user interface (UI) for supporting user interaction with communication device 200, and/or various user applications. The application processor may interface with baseband modem 206 and act as a source (in the transmit path) and a sink (in the receive path) for user data, such as voice data, audio/video/image data, messaging data, application data, basic Internet/web access data, etc. In the transmit path, protocol controller 210 may therefore receive and process outgoing data provided by application processor 212 according to the layer-specific functions of the protocol stack, and provide the resulting data to digital signal processor 208. Digital signal processor 208 may then perform physical layer processing on the received data to produce digital baseband samples, which the digital signal processor 208 may provide to RF transceiver 204. RF transceiver 204 may then process the digital baseband samples to convert the digital baseband samples to analog RF signals, which RF transceiver 204 may wirelessly transmit via antenna system 202. In the receive path, RF transceiver 204 may receive analog RF signals from antenna system 202 and process the analog RF signals to obtain digital baseband samples. RF transceiver 204 may provide the digital baseband samples to digital signal processor 208, which may perform physical layer processing on the digital baseband samples. Digital signal processor 208 may then provide the resulting data to protocol controller 210, which may process the resulting data according to the layer-specific functions of the protocol stack and provide the resulting incoming data to application processor 212. Application processor 212 may then handle the incoming data at the application layer, which can include the execution of one or more application programs with the data and/or the presentation of the data to a user via a user interface.

Memory 214 may embody a memory component of communication device 200, such as a hard drive or another similar permanent memory device. Although not explicitly depicted in FIG. 2, the various other components of communication device 200 shown in FIG. 2 may additionally each include integrated permanent and non-permanent memory components, such as for storing software program code, buffering data, etc.

In accordance with some radio communication networks, terminal devices 102 and 104 may execute mobility procedures to connect to, disconnect from, and switch between available network access nodes of the radio access network of radio communication network 100. As each network access node of radio communication network 100 may have a specific coverage area, terminal devices 102 and 104 may be configured to select and re-select available network access nodes to maintain a strong radio access connection with the radio access network of radio communication network 100. For example, terminal device 102 may establish a radio access connection with network access node 110 while terminal device 104 may establish a radio access connection with network access node 112.

In the event the current radio access connection degrades, terminal devices 102 or 104 may seek a new radio access connection with another network access node of the radio communication network 100. For example, terminal device 104 may move from the coverage area of network access node 112 into the coverage area of network access node 110. As a result, the radio access connection with network access node 112 may degrade, which terminal device 104 may detect via radio measurements such as signal strength or signal quality measurements of network access node 112.

Depending on the mobility procedures defined in the appropriate network protocols for radio communication network 100, terminal device 104 may seek a new radio access connection (which may be, for example, triggered at terminal device 104 or by the radio access network), such as by performing radio measurements on neighboring network access nodes to determine whether any neighboring network access nodes can provide a suitable radio access connection. As terminal device 104 may have moved into the coverage area of network access node 110, terminal device 104 may identify network access node 110 (which may be selected by terminal device 104 or selected by the radio access network) and transfer to a new radio access connection with network access node 110. Such mobility procedures, including radio measurements, cell selection/reselection, and handover are established in the various network protocols and may be employed by terminal devices and the radio access network in order to maintain strong radio access connections between each terminal device and the radio access network across any number of different radio access network scenarios.

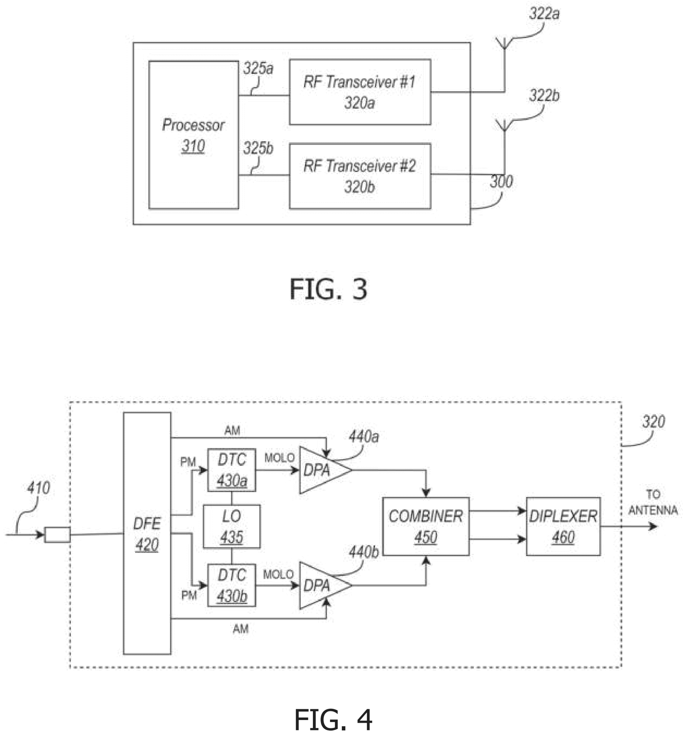

FIG. 3 shows an exemplary illustration of various communication elements of an apparatus for a wireless communication device (e.g. the communication device 200). The apparatus 300 may include processing circuitry 310 (e.g. the baseband modem 206, the application processor 212) that may direct and manage communication operations of the apparatus 300 according to one or more radio communication protocols and may control transmission/reception of communication signals over at least one or more antenna 322a-b via one or more RF transceivers 320a-b. The processing circuitry 310 may include an interface to the RF transceivers 320a-b. In this example, two RF transceivers, namely a first RF transceiver 320a and a second RF transceiver 320b are illustrated, but the apparatus 300 may include more than two RF transceivers. In an example, each RF transceiver depicted herein may be implemented by a respective integrated circuit (i.e. a transceiver integrated circuit). In accordance with various aspects described herein, the apparatus 300 may include the communication circuitry described herein, which the communication circuitry may include the RF transceivers 320a-b.

Each RF transceiver 320a-b may include at least one RF-chain to process the communication signals associated with the antenna 322a-b respectively. The apparatus 300 may include the first and second antennas 322a-b, or the apparatus 300 may include an antenna interface couplable to these antennas 322a-b. It is to be noted that the apparatus 300 is depicted as being couplable to the antennas 322a-b, but the apparatus 300 may be couplable to more than two antennas, and thereby each RF transceiver 320a-b may include a plurality of RF-chains, each RF-chain may process communication signals for a respective antenna. The apparatus 300 may transmit and receive radio communication signals with the antennas 322a-b. The apparatus 300 may act as an RF transmitter (e.g. RF transmit circuit) to transmit radio communication signals and it may also act as an RF receiver (e.g. RF receive circuit) to receive radio communication signals.

The processing circuitry 310 may include, or may be implemented, partially or entirely, by circuit and/or logic, e.g., a processor including circuit and/or logic, a memory circuit, and/or a logic, which may be configured to manage radio communication operations. The processing circuitry 310 may be configured to communicate with an external main processor (e.g. a host processor, a central processing unit, a system on chip) of the wireless communication device including the apparatus 300 via a designated interface that is coupled to the main processor. In some examples, the processing circuitry 310 may be the main processor of the wireless communication device. The processing circuitry 310 may also access the main memory of the respective wireless communication device via the designated interface. The processing circuitry 310 may further include an interface to the RF transceivers 320a-b.

The processing circuitry 310 may include a digital signal processor (e.g. the digital signal processor 208). The digital signal processor 208 may be configured to perform one or more of error detection, forward error correction encoding/decoding, channel coding, and interleaving, channel modulation/demodulation, physical channel mapping, radio measurement and search, frequency and time synchronization, antenna diversity processing, power control, and weighting, rate matching/de-matching, retransmission processing, interference cancelation, and any other physical layer processing functions.

The processing circuitry 310 may include a modem configured to process baseband signals received from/sent to the antennas 322a-b via respective communication paths 325a-b including a corresponding RF chain. In various examples, the interface to the RF transceivers 320a-b of the processing circuitry 310 may be configured to couple the processing circuitry 310 to the communication paths 325a-b. Accordingly, the processing circuitry 310 may include media-access control (MAC) circuit and/or logic, a physical layer (PHY) circuit and/or logic, a baseband (BB) circuit and/or logic, a baseband processor, a baseband memory, application processor circuit and/or logic, an application processor, an application processor memory, and/or any other circuit and/or logic. By way of example, the processing circuitry 310 can perform baseband processing on the digital baseband signals to recover data included in wireless data transmissions.

The processing circuitry 310 may control and/or arbitrate transmit and/or receive functions of the apparatus 300, and perform one or more baseband processing functions (e.g., MAC, encoding/decoding, modulation/demodulation, data symbol mapping, error correction, etc.). The processing circuitry 310 may be configured to provide control functions to the RF transceivers 320a-b (e.g. to the RF-chain to control and/or arbitrate transmitting and/or receiving radio communication signals). In aspects, functions of processing circuitry 310 can be implemented in software and/or firmware executing on one or more suitable programmable processors, and may be implemented, for example, in a field programmable gate array, application-specific integrated circuit, etc. In various examples, the interface to the RF transceivers 320a-b of the processing circuitry 310 may be configured to couple processing circuitry to the RF transceivers 320a-b to provide communication in-between.

Each RF transceiver 320a-b may provide RF processing of communication signals conveyed via a respective communication path 325a-b within a respective RF chain to transmit radio communication signals via a respective antenna based on signals (e.g. baseband communication signals, digital signals) received from the processing circuitry 310 over the communication path. Each RF transceiver 320a-b may provide RF processing of communication signals conveyed via the respective communication path 325a-b to receive radio communication signals via the respective antenna 322a-b and provide signals to the processing circuitry 310 over the respective communication path 325a-b. The processing circuity 310 may be configured to control operations of the RF transceivers 320a-b. Each RF transceiver 320a-b may include a receive path to provide RF processing to receive radio communication signals received from the respective antenna 322a-b, and a transmit path to provide RF processing to transmit radio communication signals transmitted via the respective antenna 322a-b.

In a receive (RX) path, each RF transceiver 320a-b may receive analog radio frequency signals from the respective antenna 322a-b via the respective communication path 325a-b and perform analog and digital RF front-end processing on the analog radio frequency signals to produce digital baseband samples (e.g., In-phase/Quadrature (IQ) samples) to provide to the processing circuitry 310. In various examples, each RF transceiver 320a-b may include two RF-chains per antenna element, each RF-chain may be designated for a particular polarization. Each RF transceiver 320a-b may include analog and digital reception components including amplifiers (e.g., low noise amplifiers (LNAs)), filters, RF demodulators (e.g., RF IQ demodulators)), and analog-to-digital converters, which that RF transceiver 320 may utilize to convert the received radio frequency signals to digital baseband samples.

In a transmit (TX) path, each RF transceiver 320a-b may receive digital baseband samples from processing circuitry 310 and perform analog and digital RF front-end processing on the digital baseband samples to produce analog radio frequency signals to be provided to the respective antenna 322a-b via the respective communication path 325a-b for radio transmission. Each RF transceiver 320a-b may thus include analog and digital transmission components including amplifiers (e.g., power amplifiers, filters, RF modulators (e.g., RF IQ modulators), and digital-to-analog converters, which that RF transceiver 320 may utilize to mix the digital baseband samples received from processing circuitry 310 and produce respective analog radio frequency signals for radio transmission by the respective antenna 322a-b. In some aspects, the processing circuitry 310 may control the radio transmission and reception of the RF transceivers 320a-b, including specifying the transmit and receive radio frequencies for the operation of each RF transceiver 320a-b. In some examples, at least one of the amplifiers may include an amplifier circuit provided herein.

FIG. 4 shows an exemplary illustration of a transmit path of an RF transceiver. The RF transceiver is referred to here as the RF transceiver 320 and may be the first RF transceiver 320a or the second RF transceiver 320b described in accordance with FIG. 3. The RF transceiver 320, of which its transmit path illustrated herein, may be configured for a digital polar transmitter. The RF transceiver 320 may be couplable to processing circuitry (e.g. the processing circuitry 310, a modem) over an interface. The interface may include a communication path designated to carry communication signals 410 between the processing circuitry and an antenna. In some examples, the interface may include a further circuit path to provide communication between the RF transceiver 320 and the processing circuitry for control of the operations. The RF transceiver 320 may further include further components and or circuits, such as further filter circuits, synthesizer circuits, etc. that are not depicted here. The RF transceiver 320 may include various circuits and components deployed on the respective transmission path.

The RF transceiver 320 may include various circuits and components deployed to process and transmit communication signals across two frequency bands. These components may include a digital front-end (DFE) 420, digital-to-time converters (DTCs) 430a and 430b, digital power amplifiers (DPAs) 440a and 440b, a combiner 450 and a diplexer 460.

The digital front-end 420 may receive the communication signals 410 via the interface coupling the processing circuitry to the digital front-end 420. The digital front-end 420 may include a digital front-end processing circuitry and further components. The digital front-end 420 may be configured to convert the communication signals 410 (e.g. in-phase/quadrature signals) into a polar signal including an amplitude modulation (AM) signal (e.g. amplitude control codes) which may be referred to as an amplitude modulation command or amplitude control information (sometimes bits) signal herein, and a phase modulation (PM) signal (e.g. phase control codes), which may be referred to as a phase modulation command signal or phase control information (sometimes bits) herein. Generated amplitude modulation signals and phase modulation signals may be provided to respective transmit chains for further processing.

Illustratively, in a first transmit signal path, the RF transceiver 320 may include a first digital-to-time converter 430a. The first digital-to-time converter 430a may be coupled to the digital front-end 420. The first digital-to-time converter 430a may receive the respective phase modulation signal. The first digital-to-time converter 430a may be further coupled to a local oscillator (LO) 435. The first digital-to-time converter 430a may adjust polar modulation parameters (e.g. phase of the oscillator signal) based on the phase modulation signal that the digital front-end 420 provides to generate a first modulated local oscillator signal. The first digital-to-time converter 430a may output a first modulated local oscillator (MOLO) signal. In the first transmit signal path, the RF transceiver 320 may further include a first digital power amplifier 440a. The first digital power amplifier 440a may receive the amplitude modulation signal setting the desired power of the output of the first digital power amplifier 440a. The first digital power amplifier 440a may further receive the modulated local oscillator signal and provide a first output RF signal, which is based on the received modulated local oscillator signal and amplitude modulation signal. The first digital power amplifier 440a may include a dynamic power control, or an RF-capacitive digital to analog converter (RF-CDAC).

In a second transmit signal path, the RF transceiver 320 may include a second digital-to-time converter 430b. The second digital-to-time converter 430b may be coupled to the digital front-end 420. The second digital-to-time converter 430b may receive the respective phase modulation signal. The second digital-to-time converter 430b may be further coupled to the local oscillator 435. The second digital-to-time converter 430b may adjust polar modulation parameters (e.g. phase of the oscillator signal) based on the phase modulation signal that the digital front-end 420 provides to generate a second modulated local oscillator signal. The second digital-to-time converter 430a may output a second modulated local oscillator signal. In the second transmit signal path, the RF transceiver 320 may further include a second digital power amplifier 440b. The second digital power amplifier 440b may receive the amplitude modulation signal setting the desired power of the output of the second digital power amplifier 440b. The second digital power amplifier 440b may further receive the second modulated local oscillator signal at the second frequency band and provide a second output RF signal, which is based on the received second modulated local oscillator signal and amplitude modulation signal. The second digital power amplifier 440b may include a dynamic power control, or an RF-capacitive digital to analog converter.

The local oscillator 435 may include various components to generate a stable and continuous signal at one or more designated frequencies, and may serve as a reference for frequency conversion, mixing, and other signal processing tasks. In an example, the local oscillator 435 may include an oscillator core. The oscillator core may generate signals at specified frequencies. An oscillator core may include one or more voltage controlled oscillators which may include tunable oscillators whose frequency can be adjusted by varying a control voltage. The oscillator core may include crystal oscillators that may rely on the mechanical resonance of quartz crystals. The oscillator core may include a dielectric resonator oscillators (DROs).

In some examples, the local oscillator 435 may include a resonator to determine or stabilize the frequency of oscillation. The resonator may include quartz crystals in crystal oscillators or LC circuits or dielectric resonators in voltage controller oscillators. In some examples, the local oscillator 435 may further include phase-locked loops (PLLs) to synchronize the output of the local oscillator 435 with a reference signal to facilitate high accuracy and stability with low phase noise. Illustratively, a phase-locked loop may include a reference oscillator, a phase detector, a low-pass filter, and a voltage-controlled oscillator or a tunable oscillator. The local oscillator 435 may further include a frequency control circuit that is configured to adjust the output frequency of the local oscillator 435 through various methods, such as manual tuning (e.g. potentiometers), automatic frequency control (AFC), or digital control via microcontrollers, or DSPs (e.g. via the digital front-end 420). In accordance with various aspects described herein, the local oscillator 435 may operate with a resonator that is shared with another RF transceiver. Illustratively, referring back to FIG. 4, in an example that the RF transceiver 320 is the first RF transceiver 320a, the second RF transceiver 320b may also be a transceiver that is identical or similar to the RF transceiver 320. A common resonator may be shared by local oscillators (e.g. the local oscillator 435) of these RF transceivers.

The RF transceiver 320 may further include the combiner 450 to combine the RF signals provided by the digital power amplifiers 440a-b. The combiner 450 may be configured to combine RF signals from the first transmit signal path and the second transmit signal path. Specifically, the combiner 450 may couple the RF signals output by the digital power amplifiers 440a and 440b received by the first end (e.g. input) of the combiner 450 to the second end (e.g. output) of the combiner 450 to further components of the RF transceiver 320, which are coupled to the second end of the coupler. The combiner 450 (e.g. a transformer) may facilitate proper impedance matching for both frequency bands to optimize power transfer and minimize signal reflection.

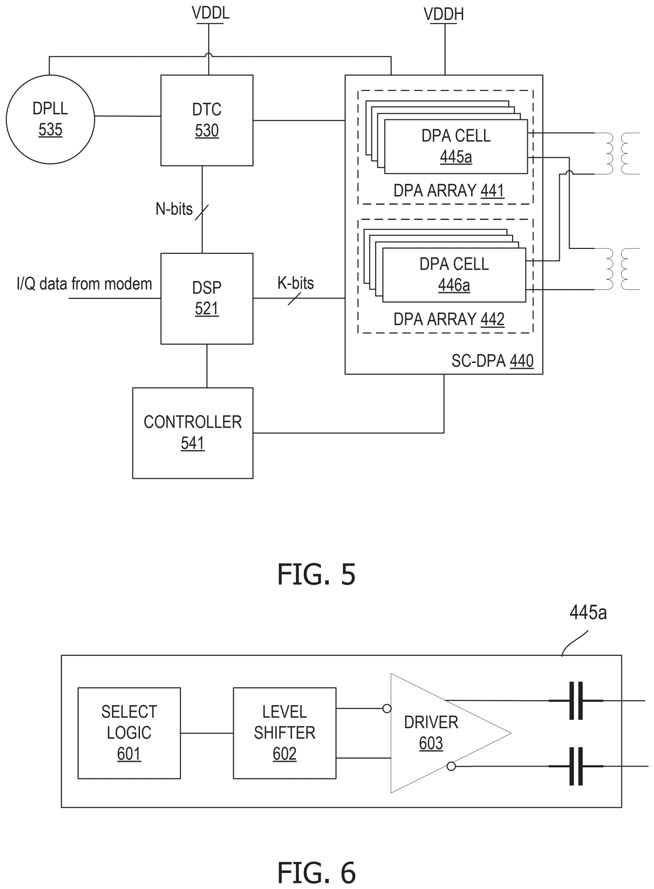

FIG. 5 illustrates a block diagram of a communication circuitry in accordance with the aspects described herein. The communication circuitry may be an RF transceiver (e.g. the RF transceiver 320). It may include a phase-locked loop (DPLL) 535 (e.g. LO 435), a digital-to-time converter (DTC) 530 (e.g. DTC 430a), a digital signal processor (DSP) 521, and a digital power amplifier 440 depicted as switch-capacitor digital power amplifier circuit (SC-DPA) (e.g. digital power amplifier 440a), which are combined in a single transmit path. In such a configuration, the phase-locked loop 535 may provide a reference clock or timing signal that may serve as a frequency or phase reference to the digital-to-time converter 530. The digital-to-time converter 530 may then use this reference to adjust the phase or timing characteristics of one or more signals that it generates, typically in response to phase information originating from the digital signal processor 521. The digital signal processor 521 may receive digital data from a modem, possibly in in-phase (I) and quadrature (Q) format, and it may be configured to produce amplitude control information indicated as K-bits, and phase control information indicated as N-bits. These bits may be used to define the amplitude of an output signal or to define a certain timing requirement that the digital-to-time converter 530 may implement. In an example, signals of a particular frequency or phase are provided to the digital power amplifier 440 to be amplified and delivered to an output coupling device, such as a transformer or balun, for driving an antenna.

The digital signal processor 521 may be configured to process I/Q data from the modem and generate amplitude and phase control information for transmission. In an example, the digital signal processor 521 may be included by a digital front-end (e.g. DFE 420). In an example, the digital signal processor 521 may transform the I/Q data into polar coordinates, producing a phase-modulation component that the digital-to-time converter 530 uses and an amplitude-modulation component that is transmitted to the digital power amplifier 440 in the form of digital bits. The digital-to-time converter 530 may receive phase-modulation information, such as N-bits, along with a reference clock from the phase-locked loop 535. The phase-locked loop 535 may be a digitally controlled phase-locked loop that locks onto a stable frequency reference and generates an output clock at a desired frequency. The digital-to-time converter 530 may then adjust the timing or phase of that clock, producing a phase-adjusted signal used by the digital power amplifier 440 or by additional elements in the transmit path. Although only one digital-to-time converter 530 is labeled in the figure, there may be scenarios where multiple digital-to-time converters are deployed in parallel or series for diverse modulation formats or for multi-band operations.

The digital power amplifier 440 may include multiple digital power amplifier arrays 441, 442. Each array may include multiple digital power amplifier cells. Illustratively, the digital power amplifier array 441 may include first multiple digital power amplifier cells including the digital power amplifier cell 445a and the digital power amplifier array 442 may include second multiple digital power amplifier cells including the digital power amplifier cell 446a. A first array 441 may be situated near the top portion of the digital power amplifier 440 block, and a second array 442 may be situated below it, but the placement of these arrays may vary from one design to another. In some embodiments, the digital power amplifier 440 may include more than two arrays, each array containing a different number of cells based on performance or power requirements. In some examples, the arrays may be partitioned logically or physically, for instance, to handle different ranges of output power, different transmit bands, or to provide redundancy to enhance reliability.

FIG. 6 shows an illustrative example of a digital power amplifier cell (e.g. digital power amplifier cell 445a) depicted in FIG. 5. A digital power amplifier cell 445a may include several sub-blocks, including select logic 601, a level shifter 602, and a driver 603. The select logic 601 may be configured to determine when that particular cell is enabled or disabled, possibly according to amplitude control bits received from the digital signal processor 521 or from other controlling logic as described herein. In some implementations, the select logic 601 may interpret certain received bits that indicate whether the amplifier cell should be active in a given modulation state. This select logic 601 may be realized using logic gates, multiplexers, or small control finite-state machines, though other techniques may also be employed, such as look-up tables in memory or configuration registers that store states for specific transmit power levels.

When the select logic 601 indicates that the amplifier cell is to be enabled, the select logic 601 may convey a control signal to the level shifter 602. This level shifter 602 may be necessary where there is a voltage difference between the logic domain in which the select logic 601 operates and the driver domain in which the high-power amplifier operation occurs. In certain scenarios, the logic domain may be at a lower supply voltage, such as VDDL, while the amplifier driver domain may be at a higher supply voltage, such as VDDH. By shifting the voltage levels appropriately, the level shifter 602 may ensure that signals are driven with sufficient amplitude to activate or deactivate the driver 603 effectively. The level shifter 602 may include transistors configured in a design that raises or lowers input signals to an appropriate voltage level, ensuring reliable switching without damaging transistors. Alternatives may include stacked MOS transistors or charge pump arrangements, depending on the semiconductor process and the voltage ranges used.

The driver 603 may include a stage or multiple stages of transistors configured to amplify or buffer the signals, typically driving an output node that is coupled to one or more capacitors. The capacitors may be part of a switched-capacitor network that forms the power delivery path to the load. In some designs, these capacitors may be arranged in parallel segments, each engaged or disengaged by the driver 603 depending on whether the amplifier cell is enabled. The driver 603 may accordingly contribute a certain amount of charge each time it switches, effectively shaping the output RF waveform. The capacitors shown in the figure next to the driver 603 may represent the load or part of the overall switching network that determines the power delivered to the antenna. In some implementations, these capacitors may be physically located at the output of the driver 603, forming a piece of the switched-capacitor digital-to-analog converter arrangement that may convert digital signals into analog waveforms at radio frequency. This switched-capacitor digital-to-analog converter approach may allow for precise control of the output power by varying the number of active cells and hence the effective capacitance contributing to the output signal.

The digital power amplifier 440 may thus operate by receiving amplitude control bits, indicated as K-bits, from the digital signal processor 521. These bits may indicate how many cells or which specific cells among 445a, 446a and others should be enabled at any one time. In accordance with various aspects described herein, by distributing these enabled cells, the digital power amplifier 440 may spread out the thermal load and reduce localized heating, particularly when the desired transmit power is below the amplifier's maximum. A controller 541 may facilitate this distribution. Illustratively, a processor (e.g. the processor 310) or a digital front-end (e.g. the DFE 420) may include the controller 541. The digital power amplifier 440 may also handle separate phases of the signal, in conjunction with the timing or phase adjustments provided by the digital-to-time converter 530. In cases where two arrays 441 and 442 are used, the controller 541 may decide to enable some portion of the first array and some portion of the second array, distributing the thermal load and controlling the overall output amplitude.

In one embodiment, the arrays 441 and 442 may each have a nominal capacity to provide a certain portion of the total output power, such that operating them together could yield a higher maximum output power. The controller 541 might choose to enable only array 441 at lower power levels, then gradually enable cells in array 442 as power needs increase. Alternatively, for efficient thermal balancing, the controller 541 may interleave cells from both arrays, toggling them in such a way that the hottest cells remain inactive while cooler cells become active, thus extending the overall lifetime of the amplifier. The digital power amplifier 440 may also incorporate internal thermal sensors or sense lines, which might interface with the digital signal processor 521 or a separate management system that informs the controller 541 about temperature profiles.

In an example, the digital signal processor 521, the digital-to-time converter 530, and the phase-locked loop 535 may be on the same integrated circuit or on different dies, depending on implementation details. The digital signal processor 521 may, for example, reside in a baseband processor or in a standalone transceiver chip, while the digital-to-time converter 530 may be located close to the digital power amplifier 440 for minimized jitter or routing complexity. The phase-locked loop 535 may be integrated with other clock generation circuitry or might be a separate module. Various supply voltages may be introduced, such as VDDL for lower-voltage logic domains and VDDH for the digital power amplifier 440's driver domain, ensuring that each stage operates optimally according to its power requirements. There may also be intermediate or additional rails, depending on the overall power management strategy.

In some implementations, the digital signal processor 521 may include a polar modulator that decomposes the baseband data into amplitude and phase components. This polar approach may be particularly well-suited to a digital power amplifier design, since the phase modulation may be performed by adjusting the clock edge or timing in the digital-to-time converter 530, while the amplitude modulation may be realized by enabling or disabling cells within the digital power amplifier 440. This separation of amplitude and phase may yield efficient transmitter architectures for various communication standards such as 5G NR, Wi-Fi, or Bluetooth, though not means limited to these specific protocols. The architecture may also support legacy systems, multi-band operation, or dynamic spectral management.

In a digital power amplifier cell 445a, the select logic 601 may receive a control bit or bits from the higher-level management block within the digital power amplifier 440. This block may interpret a combination of amplitude control bits, thermal management bits, or other signals. The output of the select logic 601 may be fed into the level shifter 602, which raises or lowers the voltage to a suitable level for the driver 603. The driver 603 may then actively drive the capacitor load. In certain variations, the driver 603 may be a CMOS inverter stage sized to deliver the appropriate current for the intended radio-frequency operation. The capacitor or capacitors attached to the driver output may be physically embodied as metal-oxide-metal (MOM) capacitors, metal-insulator-metal (MIM) capacitors, or even transistor-based capacitors, depending on the process technology. The arrangement may be repeated for each cell, and each cell may have a slightly different transistor sizing so that each contributes a fraction of the total possible power. This fractional contribution might be calibrated or tuned at manufacturing test time, ensuring uniform amplitude steps as more cells are enabled.

The design shown in FIG. 5 might be one example of how to integrate the digital signal processor 521, the digital-to-time converter 530, and the phase-locked loop 535 with the digital power amplifier 440 to form a complete transmit chain. It is to be recognized that the number of digital power amplifier arrays 441, 442 and the number of cells in each array (like 445a, 446a, and so forth) may vary depending on the desired peak output power, the frequency bands targeted, and the manufacturing constraints. The digital power amplifier 440 may receive at least two supply voltages, labeled as VDDL and VDDH. VDDL may be dedicated to the lower-voltage domains, such as the logic within the digital signal processor 521, the digital-to-time converter 530, or the internal gating logic in the digital power amplifier. VDDH may be the higher supply voltage that powers the final driver stages of the digital power amplifier cells

The digital power amplifier arrays 441 and 442 may be arranged such that each array can provide a certain incremental portion of the total power indicated by the amplitude control information. By combining multiple arrays, the circuitry may scale from low-power to high-power modes, possibly corresponding to different coverage scenarios in a wireless standard. For instance, in a mobile device scenario, the system might operate mostly in a low-power mode to conserve battery life, enabling only a fraction of the digital power amplifier 440's cells at any one time. In a base-station scenario, on the other hand, full arrays might be engaged simultaneously to achieve higher power coverage.

The digital-to-time converter 530 may incorporate a phase interpolator or digitally controlled delay line that modulates the phase of the clock signal derived from the phase-locked loop 535. By providing the adjusted phase signal to the digital power amplifier 440, the overall transmitter may achieve phase modulation in the RF domain, while amplitude modulation is handled digitally by switching the power amplifier cells on or off. The digital-to-time converter 530 might also handle fractional phase increments to achieve fractional-N synthesis or advanced modulation schemes. The data path from the digital signal processor 521 to the digital-to-time converter 530, labeled as N-bits, could define the resolution or fineness of the phase steps, for example supporting a certain number of bits of resolution for phase control. Meanwhile, the path labeled K-bits from the digital signal processor 521 to the digital power amplifier 440 might define the amplitude resolution, indicating how many cells or which cells to enable. In some scenarios, the system might incorporate dithering or dynamic bit weighting to improve spectral purity or reduce spurious outputs.

In some examples, the driver 603 may include class-D, class-E, or class-F topologies, where the capacitors at the output are selected or deselected to shape the RF waveform. The figure only shows a generic representation of capacitors, but in practice, multiple parallel capacitor segments might exist, each corresponding to a bit of the amplitude control. For example, a 5-bit amplitude control might correspond to 32 capacitor segments, each one toggled in or out by its respective digital power amplifier cell. The select logic 601 and level shifter 602 combination might then ensure each segment is activated only when needed, mitigating unintentional current leakage and heat generation.

In summary, the communication circuitry may correspond to a digital transmitter architecture that integrates a phase-locked loop 535, a digital-to-time converter 530, and a digital signal processor 521 to produce digital signals, which are subsequently amplified by a switch-capacitor digital power amplifier block 440. The digital power amplifier 440 may include multiple digital power amplifier arrays 441 and 442, each consisting of multiple digital power amplifier cells such as 445a and 446a, with each cell containing select logic 601, a level shifter 602, and a driver 603 that drives capacitors to produce the final RF output. FIG. 6 may illustrate a more detailed view of a single representative digital power amplifier cell, showing how the select logic 601 may receive control bits to enable or disable the amplifier cell, how the level shifter 602 may translate signals to the appropriate voltage domain, and how the driver 603 may interface with capacitors that contribute to the RF output signal.

In an example. the digital power amplifier 440 including a plurality of amplifier cells 445a, 446a may provide the output signal based on amplitude control information as described herein, in which each amplifier cell 445a, 446a may be switchable to contribute to the output signal. The communication circuitry may include a control circuit (e.g. controller 541) that is configured to enable a subset of the plurality of amplifier cells 445a, 446a, according to an activation sequence.

When the controller 541 enables the subset, the subset may include enabled amplifier cells arranged non-adjacently, with at least one inactive amplifier cell of the plurality of amplifier cells positioned between adjacent enabled amplifier cells. An inactive amplifier cell may refer to a digital power amplifier cell, which has not been activated to contribute to the output signal of the digital power amplifier 440 for a given amplitude control information. For example, each amplifier cell 445a, 446a in the digital power amplifier 440 may be configured to operate according to amplitude control information reflecting a desired power level or output magnitude, such that the communication circuitry takes advantage of multiple identical or near-identical amplifier cells spread over a physical layout. Each cell may include, among other components, a select logic and driver arrangement that allows the amplifier cell to be switched into or out of conduction. For example, the controller 541 may arrange the subset of enabled amplifier cells in a way that no two adjacent cells are both enabled at the same time. Because of that, the communication circuitry may ensure that at least one cell that remains inactive is interspersed between any two enabled cells, creating a non-adjacent pattern. This may address issues of local overheating by distributing active cells across the available die area.

To achieve this distribution, in an example, the controller 541 may maintain an internal mapping between each amplifier cell and the amplitude control information. It may interpret the amplitude control bits to determine how many cells should be turned on for a given output level. Instead of turning on any random or contiguous set of cells, the controller 541 may instruct the digital power amplifier 440 to operate in a non-adjacent configuration to provide the output signal, in which the output signal is generated based on the amplitude control information. For example, the mapping between each amplifier cell and the amplitude control information may represent the activation sequence. This mapping may be stored in a memory. Based on the received amplitude control information and the internal mapping, the controller 541 may enable the amplifier cells indicated by the internal mapping including information representing a mapping of the amplitude control information to a pattern of enabled cells in a non-adjacent configuration. Enabled cells in a non-adjacent configuration may include that at least one inactive amplifier cell is positioned between at least two adjacent enabled amplifier cells.

The communication circuitry may implement a broad variety of such patterns. In one example, the controller 541 may arrange cells in a checkerboard fashion, such that any cell identified as "on" (i.e. enabled) is diagonally adjacent to other on cells but never horizontally or vertically adjacent. Another example may include that the controller 541 may place each enabled cell with at least one neighbor on each side left inactive, resulting in linear or strip-like patterns that keep active units spaced out. Because digital power amplifiers often rely on multiple cells that share underlying power rails or reference voltages, turning on many adjacent cells at once may risk high current density in that small area. Aspects described herein may also facilitate avoiding this by instructing the subset of cells to be "spread out" or interleaved with inactive cells.

Each amplifier cell being switchable to contribute to the output signal may include a local gating function that blocks or enables conduction. The amplitude control bits may pass through the controller 541, which can decide which cells are part of the subset. The controller 541 may then signal the by the controller 541 to drive charge or current into the load. The non-adjacency ensures that, even when many cells are turned on to achieve a higher output power, no localized cluster of active cells.

In an example, the controller 541 may obtain information representing the layout geometry of the digital power amplifier 440 to identify which cells are adjacent. This information may be stored in a memory. For example, the adjacency definition may be row-based, column-based, or even diagonal, depending on how strictly the active cells are to be separated. Second, the controller 541 may translate the amplitude control bits into a selection pattern (e.g. activation sequence) that satisfies non-adjacency. If the amplitude control bits request a larger power, the controller 541 may enable more cells in a non-adjacent configuration as long as the desired output level and/or amplitude control information allows a translation to the non-adjacent configuration . The controller 541 may accordingly instruct the digital power amplifier 440 to provide corresponding gating signals that physically turn each cell on or off. The controller 541 may further facilitate the generation of the correct voltage levels and timing signals.

In an example, the controller 541 may facilitate the operation in non-adjacent configuration by maintaining a stored list of cell subsets for amplitude levels that the amplitude control information may indicate. Illustratively, each amplitude level of multiple amplitude levels indicatable by the amplitude control information may be mapped to a respective predefined subset of cells to be enabled, which the subset has a respective non-adjacent configuration. The multiple amplitude levels mentioned in the previous sentence may refer to all amplitude levels or only some of amplitude levels that may allow non-adjacent configurations.

As an illustrative example, in case the amplitude control bits indicate that 10 cells should be enabled, the controller 541 may obtain a "10-cell pattern" from memory. In an example, the controller 541 may verify that no two of these 10 cells are physically adjacent in the circuit layout. Should the amplitude request increase to 11, the controller 541 may obtain an "11-cell pattern" from the memory, which also satisfies the non-adjacency configuration. Alternatively, the controller 541 may compute on the fly which cells to place in the subset by scanning a bit mask and skipping positions that would be adjacent to an already-enabled cell.

The controller 541 may define adjacency in various manners. For example, adjacency may refer to purely along one dimension, meaning that two cells in the same row are considered adjacent but not two cells in neighboring rows. In another example, adjacency may refer to adjacency along both row and column directions, ensuring that each active cell is surrounded in all cardinal directions (and possibly diagonal directions) by inactive cells. A non-adjacent configuration may include any configuration that leaves at least one inactive cell between two enabled cells (two cells that are turned on).

In some examples, the non-adjacent configuration may be beneficial even if the amplitude control bits only rarely request higher powers. For instance, in a mobile device that typically transmits at moderate levels, there may be occasional bursts of maximum power. The controller 541 can ensure that, even in those bursts, the non-adjacent configuration is applied by the digital power amplifier 440. This approach may extend the device's operating lifetime by preventing repeated thermal stress in a single region of the chip. It also may enable the manufacturer to produce a more compact integrated circuit if it knows the adjacency rule will be respected because local hot spots do not force as large thermal margins around each cell.

In an example the controller 541 may enable the subset of the plurality of amplifier cells based on a plurality of activation sequences including the activation sequence, each representing a distinct pattern to selectively enable the amplifier cells. Each distinct pattern may represent a unique distribution of active cells satisfying non-adjacency based on a given amplitude control information. For example, one pattern may enable cells in every other position along a row, while another pattern may enable them in a checkerboard arrangement. In some examples, multiple sequences may be arranged, such that each activation sequence is for balancing a respective performance goal distinct from other performance goals associated with other activation sequences. For example, a memory may store these activation sequences or the controller 541 may compute them from a stored algorithm.

In an example, the controller 541 may select the activation sequence of the plurality of activation sequences based on a predetermined operating condition. Correspondingly, the controller 541 may choose which activation sequence to employ at a given time. The predetermined operating condition may be, for example, a particular power level threshold, a battery voltage, or an operational mode indicated by the device including the communication circuitry. Illustratively, if the device or the communication circuitry or the controller 541 is in a low-power state, the controller 541 may select a minimal activation sequence that may refer to a low power non-adjacent configuration. If it transitions to a high-power state, the controller 541 may select a more aggressive sequence that may refer to a higher-power non-adjacent configuration, which may respond to user demands or environmental conditions without manual intervention. For example, the controller 541 may include comparators that watch for a certain register to exceed a threshold, triggering a change in the chosen pattern.

In an example, the controller 541 may select the activation sequence of the plurality of activation sequences based on a thermal feedback received from a temperature sensor. The thermal feedback may include real-time thermal data. If a temperature sensor indicates an excessive local temperature, the controller 541 may select a more dispersed pattern that activates cells across multiple areas to lower the temperature in any single region.

For example, the communication circuitry may include one or more temperature sensors disposed in or near the digital power amplifier 440. The temperature sensor may be placed in close proximity to the digital power amplifier arrays 441 and 442 so that real-time thermal conditions of the digital power amplifier 440 can be monitored. Alternatively, the sensor may be located at a central region of the die or at peripheral locations where heat accumulation is known to occur. The controller 541 may receive temperature sensor data and may determine a different sequence is needed. Illustratively, the controller 541 may obtain the sensor data over a bus or an analog-to-digital interface, and the controller 541 may then choose from its library of activation sequences.

In an example, there may be progressive threshold levels present to select the activation sequence. For example, if the temperature crosses a first threshold, the controller 541 may select a first activation sequence corresponding to a first pattern. If it crosses a second threshold, the controller 541 may select a second activation sequence corresponding to a second pattern. In an example, the controller 541 may read the temperature sensor's output and trigger an application of a non-adjacent configuration when the temperature exceeds a predefined threshold, for example, when the digital power amplifier 440 is previously configured for an adjacent or random configuration. Once the temperature returns below the threshold, the controller 541 may revert to a less conservative pattern, disable certain non-adjacent requirements, and/or revert back to the adjacent or random configuration.

In an example, the controller 541 may select the activation sequence based on the amplitude control information. For example, the amplitude control bits might directly select from among the stored patterns, or the controller 541 may select an activation sequence that accounts for amplitude as well as possibly other metrics. If a received amplitude control information corresponds to moderate power, the controller 541 may select a correspondingly moderate pattern. If the amplitude control information corresponds to high power (e.g. above a certain threshold), the controller 541 may select a pattern that enables many cells while still preserving non-adjacent configuration.

In an example, the controller 541 may adaptively switch from a first activation sequence of the plurality of activation sequences to a second activation sequence of the plurality of sequences. Instead of a one-time selection, the controller 541 may continually reevaluate and switch sequences if designated conditions shift. For instance, if the device transitions from a moderate load to a heavy load, or if the temperature rises unexpectedly, the controller 541 may abandon the previously selected first sequence in favor of another. In an example, the controller 541 may assign references to multiple patterns in memory, each pattern labeled with an identifier that indicates when it should be used.

For example, the controller 541 may alternate between the activation sequences in cycles to vary which amplifier cells are enabled. Illustratively, the controller 541 may facilitate such alternation even if the operating condition or amplitude control remains constant, such that the apparatus may cycle among multiple designated sequences to distribute usage among different sets of cells over time. Functionally, this can reduce wear on specific cells that might otherwise remain active too frequently. In an example, the controller 541 can track time or usage cycles and regularly switch from one pattern to another.

In another example, the controller 541 may observe multiple input parameters-such as recent communication circuitry usage history, measured temperature trends over time, or predicted future load demands-and dynamically decide when to transition between activation sequences. Illustratively, the controller 541 may compare the accumulated thermal exposure of various amplifier cells or evaluate performance metrics such as linearity or efficiency. The controller 541 may, for instance, adopt a weighted usage scheme where cells that have been active more frequently are given a temporary "rest" period in the next sequence cycle. In an example, the controller 541 may alternate between the activation sequences in cycles to vary which amplifier cells are enabled.

In an example, the amplifier cells may be arranged in a two-dimensional matrix comprising multiple rows and multiple columns on a substrate. In other words, the digital power amplifier 440 may be implemented as a grid of amplifier cells, each at a unique row-column intersection. The controller 541 may assign a respective identifier for each amplifier cell, which may represent the amplifier cell's position in row and column coordinates, and enable the amplifier cells to be enabled in a non-adjacent configuration by providing control signals to corresponding cells.

In an example, the controller 541 may enable the subset of the amplifier cells, such that first rows of the multiple rows include the enabled amplifier cells and at least one second row of the multiple rows includes a plurality of inactive cells, in which the at least one second row may be disposed between adjacent rows of the first rows. In an example, the controller 541 may designate entire rows as "active" or "inactive. For example, row 0 may contain active cells, row 1 may remain inactive, row 2 may contain active cells again, and so on. By sandwiching an inactive row between two active ones, the provided pattern ensures no direct adjacency between two active rows. Illustratively, the controller 541 may handle row-based gating lines such that row 0 and row 2 receive the gating signals while row 1 remains deactivated. This approach is particularly straightforward when each row shares certain power or control lines, making it easy for the apparatus to skip entire rows. In an example, active cells and inactive cells may be defined by certain segments of rows instead of entire rows, in which the segments include at least two adjacent amplifier cells.

In an example, first columns of the multiple columns may include the enabled amplifier cells and at least one second column of the multiple columns may include a plurality of inactive cells, in which the at least one second column is disposed between adjacent columns of the first columns. Similar to the row-based approach, this activation sequence may facilitate that entire columns remain off between active columns. An example might be enabling columns 0, 2, and 4, while columns 1 and 3 remain inactive, guaranteeing that no two enabled columns stand side by side. Illustratively, the communication circuitry may have column-based gating lines that the controller 541 drives, which are used to switch entire columns into an active or inactive state. In an example, active cells and inactive cells may be defined by certain segments of columns instead of entire columns, in which the segments include at least two adjacent amplifier cells.

In an example, the activation sequence may cause the digital power amplifier 440 to uniformly distribute the enabled amplifier cells among the plurality of amplifier cells, such that the enabled amplifier cells are positioned at regular intervals with a number of inactive amplifier cells interposed between adjacent enabled amplifier cells along at least one dimension of the matrix. This may result in a more refined pattern in which the distribution is not just about skipping a row or column but placing active cells at consistent intervals. For example, the activation sequence may result in a pattern that places an enabled cell every other position in a row, or a pattern that leaves a consistent gap of two inactive cells between any two active cells.

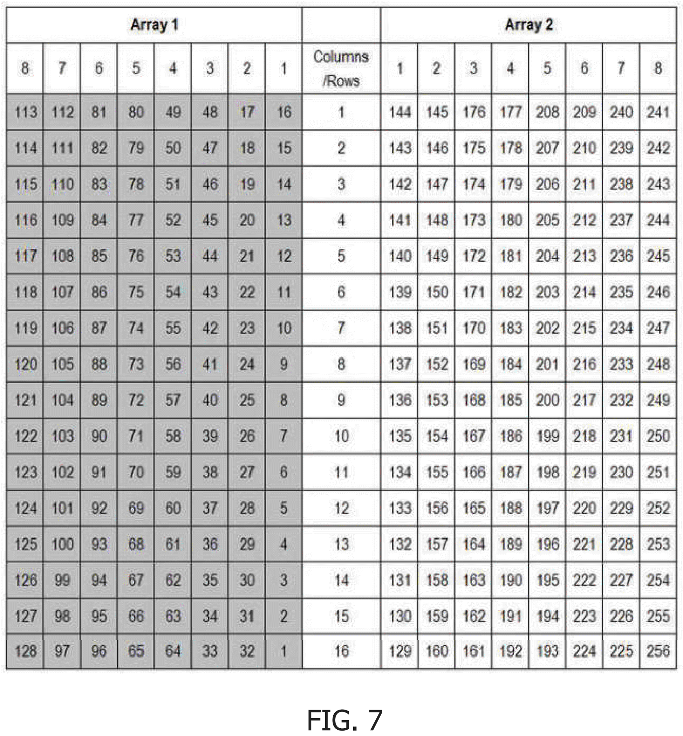

FIG. 7 shows an illustrative example of a digital power amplifier operation. The digital power amplifier may be the digital power amplifier 440 described herein. In this illustrative example, each amplifier cell in a given row and column is activated in a sequential, adjacent manner as indicated by the numbers shown in the figure. The illustration depicts two digital power amplifier arrays (e.g. digital power amplifier arrays 441, 442 ), labeled as "Array 1" and "Array 2," each containing 8 columns and 16 rows of cells. The numbers in each cell represent an exemplary order in which the amplifier cells may be operated when ramping up the output power. Illustratively, as the amplitude control information (e.g., from the digital signal processor 521) requests increasingly higher power levels, the controller 541 may enable cells according to their assigned consecutive indices. By referencing columns and rows in a linear progression, this scheme may place newly activated cells immediately next to ones already active, thereby forming a contiguous block of active cells in each row.

For example, the controller 541 may interpret the amplitude control information as a direct instruction to enable an integer number of cells in ascending order. If the amplitude bits suggest that a certain power level corresponds to enabling the first X cells, the controller 541 may activate cells in what is effectively numerical order: column 1 row 16, then column 2 row 16, column 3 row 16, and so on across the row until it has satisfied the total desired for that amplitude setting. If further increments are needed, the controller 541 may proceed down the table or across the columns, enabling adjacent cells. Correspondingly, each increment in power corresponds to activating the next immediate neighboring cell in the array. Thus, if the amplitude control information corresponds to an illustrative value of 128, one might find that all the amplifier cells from column 1 row 16 through column 8 row 16 in Array 1 are enabled in a contiguous block.

To summarize some above-mentioned aspects, the controller 541 may enable the subset of the plurality of amplifier cells according to an activation sequence, in which the activation sequence represents an order in which amplifier cells are to be enabled. The controller 541 may enable the subset in accordance with the order indicated by the activation sequence based on the amplitude control information. the order being determined based on the amplitude control information. Illustratively, the controller 541 may enable the subset of amplifier cells such that, for a given amplitude control value, a corresponding number of amplifier cells are enabled in an order defined by the activation sequence, wherein the activation sequence prescribes a predefined arrangement of amplifier cells, and the controller 541 selects and enables amplifier cells following the prescribed order until the number of enabled amplifier cells corresponds to the amplitude control information. In this particular example, for a given amplitude control value, a corresponding number of amplifier cells are activated sequentially in accordance with the activation sequence corresponding to an adjacent configuration. The controller 541 may retain a lookup or an algorithm that interprets the amplitude as a request to activate the first N cells according to the strict sequence described by the numbering in the table. Each cell may include hardware such as the select logic 601, a level shifter 602, and a driver 603, which together determine whether the amplifier cell is active.

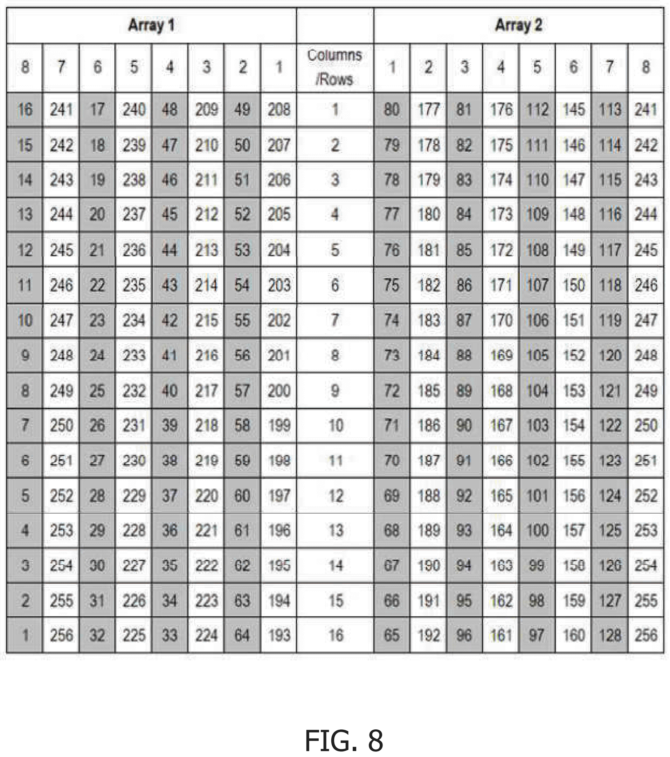

FIG. 8 shows an illustrative example of a digital power amplifier operation. The digital power amplifier may be the digital power amplifier 440 described herein. Each amplifier cell in two digital power amplifier arrays (e.g. digital power amplifier arrays 441, 442), denoted "Array 1" and "Array 2," is illustrated with labels of a specific number representing an illustrative activation order. Instead of proceeding row by row or column by column in a contiguous pattern, these numbers have been arranged so that physically neighboring cells are assigned different numbers.

Two digital power amplifier arrays are depicted, each with 8 columns and 16 rows, for a total of 128 cells per array. The numbers in each cell identify its place in the non-adjacent activation order. Because the arrays are arranged on a substrate in a two-dimensional grid, adjacent cells (in both the row and column directions) may be ordinarily prone to generating localized thermal clusters if activated at once. By assigning these cells labels as shown that are far apart in the 1-256 sequence, the corresponding activation sequence can ensure that at intermediate amplitude levels-e.g., 32, 64, 128-any newly enabled cell is physically remote from those already in operation. Consequently, the controller 541 may take the amplitude control bits from, for instance, the digital signal processor 521, and may interpret them as a request for a certain number of active cells. The controller may then proceed to enable cells numbered from 1 up to that target count according to the arrangement shown in the figure.

For example, each cell in the arrays may include sub-blocks such as select logic 601, a level shifter 602, and a driver 603. The controller 541 may send gating signals to each cell's select logic based on the activation sequence representing identifier (e.g. assigned label) of that cell. Thus, if 64 cells are enabled, the amplifier cells labeled 1 through 64 may receive "on" signals, while the higher-numbered cells remain off. By the time the amplitude level needs 96 cells, the controller 541 may extend the range of enabled labels to 1 through 96, bringing more spatially separated cells online. Throughout this process, no step in the progression results in a block of closely spaced active cells, thanks to the numbering scheme that assigns distant labels to physically neighboring cells.

As an illustrative result, when amplitude control bits specify that 32 cells are to be enabled, the controller 541 may activate the amplifier cells labeled from 1 to 32, and because these labeled cells are physically spaced, no two adjacent amplifier cells are turned on in the same step. If the amplitude control bits request that 64 cells be enabled, the controller 541 may activate cells labeled from 1 to 64, again distributing active cells so that no local region experiences excessive heat concentration.

In effect, the depicted order numbers of the amplifier cells can be seen as a look-up index for the controller 541. When the amplitude control bits indicate a desired number of active cells (N), the controller 541 may reference the amplifier cells with labels 1 through N in ascending order. Each label may indicate a physical position in one of the two arrays-either Array 1 or Array 2-and may be assigned to ensure that physically neighboring cells have non-consecutive numbers at least along one axis.

To summarize for this illustrative example, the controller 541 may enable the subset of the plurality of amplifier cells according to an activation sequence, in which the activation sequence represents an order in which amplifier cells are to be enabled. The controller 541 may enable the subset in accordance with the order indicated by the activation sequence based on the amplitude control information. The order being determined based on the amplitude control information. Illustratively, the controller 541 may enable the subset of amplifier cells such that, for a given amplitude control value, a corresponding number of amplifier cells are activated in ascending order as prescribed by the activation sequence.

For example, when the amplitude control bits correspond to an amplitude level that demands a certain number of cells (e.g., 32, 64, or 128), the controller 541 may reference the activation sequence defined by the assigned numbers to enable the appropriate amount of cells. The cells may be enabled by following the order of their assigned labels, starting from the first enabled amplifier cell and proceeding through the activation sequence for the desired number of cells. The general operation is such that for, say, 32 active cells requested, the first 32 cells in the sequence (labeled from 1 to 32 in the map) are enabled. If the request increases to 64, the next 32 cells in the sequence (from 33 to 64) are activated without physically adjacent cells being enabled simultaneously.

In some cases, depending on the amplitude request, the controller 541 may gradually expand the number of active cells by referencing the next set of numbers in the sequence, ensuring that cells located far apart in physical space are activated to prevent overheating. These activation instructions may be implemented systematically by the controller 541, which sends control signals to the select logic of each cell to trigger this activation.

In this illustrative example, the controller 541 may refer to an activation sequence in which each amplifier cell is assigned a specific position in an ordered list. The amplitude control information indicates how many cells should be activated to achieve a desired output power. Accordingly, when the amplitude control value corresponds to enabling N cells, the controller 541 may traverse the activation sequence and may enable those cells labeled from 1 through N in that prescribed list. Because each amplifier cell occupies a predefined position in the activation sequence, the controller 541 may simply select and enable the first N entries of that sequence to reach the target output level. Once the requisite number of cells has been enabled, any remaining cells in the sequence beyond position N remain inactive until a higher amplitude control value is requested. Thus, for each amplitude control value, a distinct subset of amplifier cells may be enabled in the order dictated by the activation sequence.

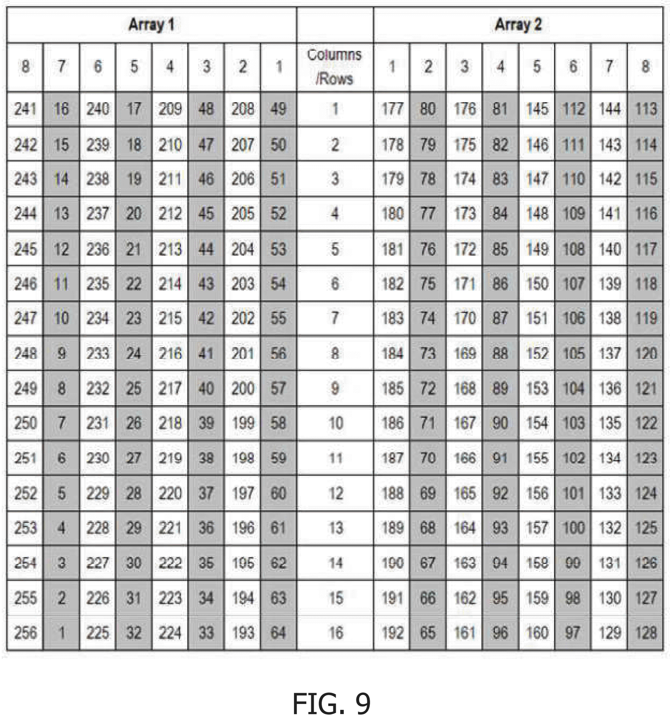

FIG. 9 shows an illustrative example of a digital power amplifier operation. The digital power amplifier may be the digital power amplifier 440 described herein. In the figure, two digital power amplifier arrays (e.g. digital power amplifier arrays 441, 442) labeled "Array 1" and "Array 2" once again illustrate an eight-column by sixteen-row matrix of amplifier cells, with each cell labeled by a unique number from 1 to 256. As with other non-adjacent configurations, these numbers specify an intended activation order that aims to separate the enabling of physically neighboring cells. Although the overall concept is similar to that shown in FIG. 8, this new figure presents a different labeling scheme, reflecting a distinct activation sequence presented in FIG. 8. Each cell's label may identify the point in the sequence at which that cell is activated if the amplitude control bits call for that many cells. When the amplitude control bits request N cells, the controller 541 may enable the amplifier cells corresponding to the labels from 1 through N in ascending order and may ensure that cells assigned to indices beyond N remain inactive.

The differences from the earlier sequence presented in FIG .8 can be observed by comparing which rows and columns receive lower-numbered labels. In the previous diagram, one might have noticed certain rows or corners systematically receiving the earliest indices. Here, the pattern for labeling is altered so that the distribution of low-numbered cells is scattered in new ways. The principle, however, remains consistent: by distributing the earliest labels (those enabled at lower amplitude levels) among physically distant locations, the arrangement avoids adjacent enabling cells at least at an axis of the matrix provided by the amplifier cells.

The controller 541 may address each row and column in both arrays through dedicated or shared gating signals. Each amplifier cell in a row-column intersection may have local components such as select logic 601, a level shifter 602, and a driver 603. The select logic 601 may determine whether the driver 603 is enabled based on a signal that references the assigned label of that cell relative to the amplitude control bits. If the amplitude control requires, for instance, 96 active cells, the controller 541 may check the stored or computed activation sequence representing the ordering to identify cells labeled 1 through 96. Each of those cells then may receive an "enable" command via its select logic 601, possibly traveling through the level shifter 602 if there is a need to shift from a low-voltage logic domain (e.g. VDDL) to a higher voltage supply (e.g. VDDH) that powers the driver 603.

The controller 541 may store or dynamically generate this labeling structure in internal memory. When the amplitude control bits come from the digital signal processor 521 or a similar source, the controller 541 may look up how many cells must be turned on and thereby may select the amplifier cells from label 1 up to label N for a non-adjacent configuration. In an example, the communication circuitry can further refine which arrays are engaged at lower power levels, possibly only enabling a fraction of the amplifier cells from Array 1 if the requested amplitude is modest, but as soon as the communication circuitry needs to provide an output at a higher amplitude, the controller 541 may move up in the numeric sequence, enabling cells from Array 2's labeling as well. The important difference from a contiguous numbering approach is that lower numbers in Array 2 may often be chosen to be physically distant from the lower numbers in Array 1, so that, for example, turning on cells labeled 1 through 80 does not result in a cluster in one corner.

Because each cell may physically be identical from an operational standpoint, the identifier (i.e. label) may be purely a matter of controlling the order in which the select logic 601 is activated. Once the controller 541 may command a cell to turn on, that cell's driver 603 may contribute to the total output power. The difference, then, lies in how the identifier ensures that cells with physically nearby coordinates do not share consecutive or nearly consecutive labels, preventing them from collectively switching on at the same amplitude step. It may be worth noting that if the amplitude request is large enough to eventually enable all 256 cells, the final scenario is the same-every cell is active. The advantage of the non-adjacent configuration emerges primarily during all intermediate steps, which in practice represent the majority of typical operation, since peak power is not used constantly. Because each progressive step from 1 to N is widely dispersed across the arrays, the digital power amplifier may experience a slower, more uniform thermal gradient.

In an example, the activation sequence may be representative of a mapping of the amplitude control information to a binary pattern representing enabled and inactive states for the amplifier cells. Illustratively, the amplitude control bits might directly select which cells end up on or off. If the apparatus has a 10-bit amplitude control code, that code might correspond to a 1024-entry table that encodes binary masks for the digital power amplifier cells. The adjacency rule may be satisfied by arranging the activation sequence to ensure that a corresponding binary mask does not allow two adjacent cells to be both set to be enabled. Based on a received amplitude control information, the controller 541 may obtain the respective binary pattern from a memory and may apply the pattern to the gating of each cell.

In an example, the controller 541 may determine which amplifier cells are to be enabled for generating the output signal based on a selected activation sequence. Illustratively, this may include setting certain gating signals to 'active' for those cells to be enabled and 'inactive' for others.

In an example, the controller 541 may generate switching signals to selectively switch each amplifier cell into an enabled state when the selected activation sequence indicates an activation for that cell, and into an inactive state when the selected activation sequence indicates deactivation for that cell. In an example, the controller 541 may couple the select logic of each cell, which then triggers the level shifter of that cell. The controller 541 may include a logic circuitry or a small processor that generates distinct gating signals for each amplifier cell. Internal address decoders or multiplexing stages may route these signals to reach the correct subset of cells indicated by the selected activation sequence. For example, the controller 541 may include memory registers or look-up tables that store which cells to enable for each amplitude code or operational state.

Each amplifier cell may include select logic 601, a level shifter 602, and a driver 603 arranged so that the gating signals from the controller 541 can propagate to the amplifier cell's driver domain. The select logic 601 may receive a digital enable signal corresponding to the amplifier cell's assigned index and activation status. This logic may then drive the level shifter 602, which converts the lower-voltage control signal into a higher-voltage domain (e.g., VDDH) suitable for switching the driver 603. The driver 603 itself may include one or more transistors and capacitive elements that couple power to the output node of the digital power amplifier. When the controller 541 asserts a gating signal for that cell, the amplifier cell may transition from an off state-where it contributes no charge or current-to an on state, actively delivering a share of the overall output power.

The amplitude control information described herein may be indicative of a desired output power level. Each active cell may contribute an incremental portion of power, so if the code requests a higher level, the controller 541 may enable more cells. Because the adjacency rule is in play, the controller 541 may determine whichever subset best achieves that power. Correspondingly, the enabled amplifier cells may contribute to the output signal, and the inactive amplifier cells may be excluded from a contribution to the output signal. Hence, only the enabled cells actually drive current or charge into the load, while the inactive cells are effectively decoupled. Each amplifier cell may include gating transistors or driver stages that remain in an off state if the controller 541 designates that cell as inactive.

As also illustrated herein, the digital power amplifier 440 can include a plurality of cell arrays, which may be 2 cell arrays as illustrated herein or any integer number of cell arrays, such as 3, 4, 5, 10, etc. Furthermore, the controller 541 may enable a particular number of cells within the multiple arrays as indicated by the amplitude control information, such that the amplitude of the output signal is proportional to the number of the enabled amplifier cells. For example, in digital power amplifiers, the output voltage signal may be linearly proportional to number of operating cells. This means that operating 2 full arrays will result in doubling the magnitude of the output signal (or increasing the output power by 6dB).

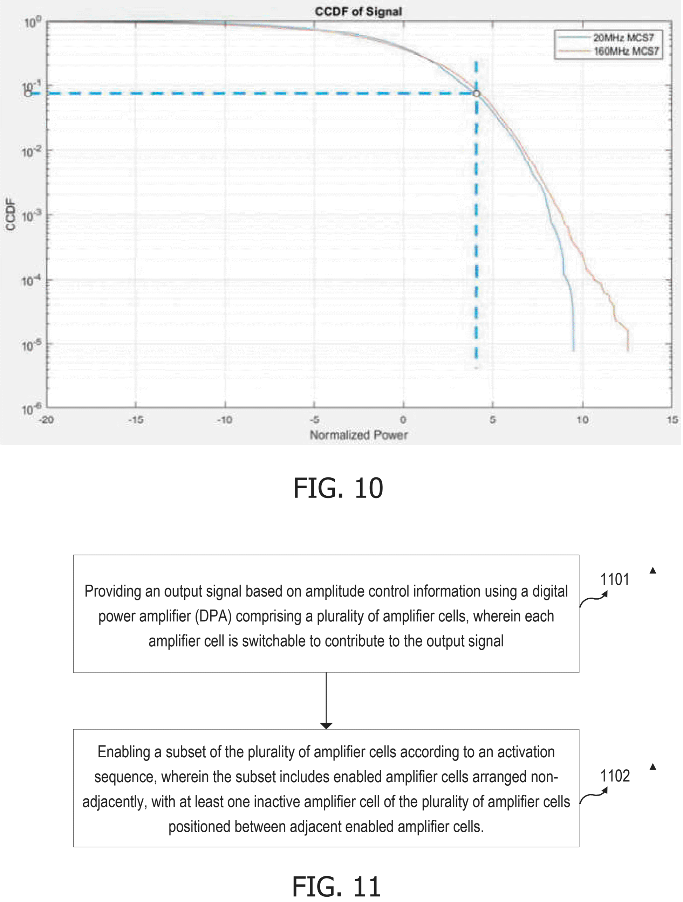

FIG. 10 illustrates an example of a complementary cumulative distribution function in accordance with various aspects described herein. The plot depicts the complementary cumulative distribution function (CCDF) for a transmitted signal under MCS7 modulation, illustrating the statistical likelihood of various output power levels occurring over time. In particular, the curve indicates that reaching power levels corresponding to a 6 dB back-off from the maximum output (which may require activating both digital power amplifier arrays for double the power) happens under 5% of operating conditions. Hence, for roughly 95% of transmission time, the transmitter operates in a lower power state, meaning that only about half of the available amplifier cells are enabled. This observation derives from the linear relationship between the number of active cells and the output voltage amplitude, where doubling the amplifier cells may yield approximately a 6 dB increase in output power.

Illustratively, in a communication circuitry including a substrate on which a first pair of digital power amplifier arrays are disposed around one corner of the substrate and a second pair of digital power amplifier arrays are disposed around another corner of the substrate, when each pair was operating in a configuration in which one digital power amplifier array operates in adjacent configuration, the core temperature of those arrays are simulated to be around 130-131 degree Celsius. On the other hand, when these pairs are instructed to operate in a non-adjacent configuration to distribute the enabled cells within the pair, the core temperatures were simulated around 120-123 degrees Celsius, which indicate an average 8.4 degree Celsius temperature reduction. Illustratively, the application of the non-adjacent configuration may be identified by thermal inspection of a digital power amplifier operated at BO (Back Off). In this scenario, sweeping the output signal from low to high power may result in hot temperature spots that are to be seen in several locations across digital power amplifier arrays.

FIG. 11 shows an example of a method. The method may include: providing 1101 an output signal based on amplitude control information using a digital power amplifier (DPA) comprising a plurality of amplifier cells, wherein each amplifier cell is switchable to contribute to the output signal; and enabling 1102 a subset of the plurality of amplifier cells according to an activation sequence, wherein the subset includes enabled amplifier cells arranged non-adjacently, with at least one inactive amplifier cell of the plurality of amplifier cells positioned between adjacent enabled amplifier cells. A computer-readable medium may store instructions which, if executed, cause a processor to perform the method.

The following examples pertain to further aspects described herein.

Example 1 may include the subject matter of an apparatus including: a digital power amplifier (DPA) including a plurality of amplifier cells configured to provide an output signal based on amplitude control information, wherein each amplifier cell is switchable to contribute to the output signal; and a control circuit (i.e. controller) configured to enable a subset of the plurality of amplifier cells according to an activation sequence, wherein the subset includes enabled amplifier cells arranged non-adjacently, with at least one inactive amplifier cell of the plurality of amplifier cells positioned between adjacent enabled amplifier cells.

Example 2 may include the subject matter of example 1, wherein the control circuit is further configured to enable the subset of the plurality of amplifier cells based on a plurality of activation sequences including the activation sequence, each representing a distinct pattern to selectively enable the amplifier cells.

Example 3 may include the subject matter of example 2, wherein the control circuit is configured to select the activation sequence of the plurality of activation sequences based on a predetermined operating condition.

Example 4 may include the subject matter of example 2 or example 3, wherein the control circuit is configured to select the activation sequence of the plurality of activation sequences based on a thermal feedback received from a temperature sensor.

Example 5 may include the subject matter of any one of examples 2 to 4, wherein the control circuit is further configured to select the activation sequence based on the amplitude control information.

Example 6 may include the subject matter of any one of examples 2 to 5, wherein the control circuit is configured to adaptively switch from a first activation sequence of the plurality of activation sequences to a second activation sequence of the plurality of sequences.

Example 7 may include the subject matter of any one of examples 2 to 6, wherein the control circuit is further configured to alternate between the activation sequences in cycles to vary which amplifier cells are enabled.

Example 8 may include the subject matter of any one of examples 1 to 7, wherein the amplifier cells are arranged in a two-dimensional matrix including multiple rows and multiple columns on a substrate.

Example 9 may include the subject matter of example 8, wherein first rows of the multiple rows comprise the enabled amplifier cells and at least one second row of the multiple rows comprise a plurality of inactive cells including the at least one inactive amplifier cell, wherein the at least one second row is disposed between adjacent rows of the first rows.

Example 10 may include the subject matter of example 8 or example 9, wherein first columns of the multiple columns comprise the enabled amplifier cells and at least one second column of the multiple columns comprise a plurality of inactive cells including the at least one inactive amplifier cell, wherein the at least one second column is disposed between adjacent columns of the first columns.

Example 11 may include the subject matter of any one of examples 8 to 10, wherein the activation sequence is configured to uniformly distribute the enabled amplifier cells among the plurality of amplifier cells, wherein the enabled amplifier cells are positioned at regular intervals with a number of inactive amplifier cells interposed between adjacent enabled amplifier cells along at least one dimension of the matrix.

Example 12 may include the subject matter of any one of examples 1 to 11, wherein the activation sequence is representative of a mapping of the amplitude control information to a binary pattern representing enabled and inactive states for the amplifier cells.

Example 13 may include the subject matter of any one of examples 1 to 12, wherein the control circuit is configured to determine which amplifier cells are to be enabled for generating the output signal based on a selected activation sequence.

Example 14 may include the subject matter of example 13, wherein the control circuit is configured to generate switching signals to selectively switch each amplifier cell into an enabled state when the selected activation sequence indicates an activation, and into an inactive state when the selected activation sequence indicates deactivation.

Example 15 may include the subject matter of any one of examples 1 to 14, wherein the amplitude control information is indicative of a desired output power level.

Example 16 may include the subject matter of any one of examples 1 to 15, wherein the enabled amplifier cells are configured to contribute to the output signal, and the at least one inactive amplifier cell is excluded from a contribution to the output signal.

Example 17 may include the subject matter of any one of examples 1 to 16, wherein the DPA includes a plurality of cell arrays including the plurality of amplifier cells.

Example 18 may include the subject matter of any one of examples 1 to 17, wherein the enabled amplifier includes a number of amplifier cells of the plurality of amplifier cells, wherein the number is based on the amplitude control information.

Example 19 may include the subject matter of example 18, wherein an amplitude of the output signal is proportional to the number of the enabled amplifier cells.

Example 20 may include a communication circuit including: the apparatus of any one of examples 1 to 19; and a digital-to-time converter configured to provide a phase modulated signal to the apparatus.

Example 21 may include the communication circuit of example 20, which may further include a processor configured to provide the amplitude control information to the apparatus and phase control information to the digital-to-time converter.

Example 22 may include the subject matter of a method including: providing an output signal based on amplitude control information using a digital power amplifier (DPA) including a plurality of amplifier cells, wherein each amplifier cell is switchable to contribute to the output signal; and enabling a subset of the plurality of amplifier cells according to an activation sequence, wherein the subset includes enabled amplifier cells arranged non-adjacently, with at least one inactive amplifier cell of the plurality of amplifier cells positioned between adjacent enabled amplifier cells.

Example 23 may include the subject matter of example 22, and may further include enabling the subset of the plurality of amplifier cells based on a plurality of activation sequences including the activation sequence, each representing a distinct pattern to selectively enable the amplifier cells.

Example 24 may include the subject matter of example 23, and may further include selecting the activation sequence of the plurality of activation sequences based on a predetermined operating condition.

Example 25 may include the subject matter of example 23 or example 24, and may further include selecting the activation sequence of the plurality of activation sequences based on a thermal feedback received from a temperature sensor.

Example 26 may include the subject matter of any one of examples 23 to 25, and may further include selecting the activation sequence based on the amplitude control information.

Example 27 may include the subject matter of any one of examples 23 to 26, and may further include adaptively switching from a first activation sequence of the plurality of activation sequences to a second activation sequence of the plurality of activation sequences.

Example 28 may include the subject matter of any one of examples 23 to 27, and may further include alternating between the activation sequences in cycles to vary which amplifier cells are enabled.

Example 29 may include the subject matter of any one of examples 22 to 28, wherein the amplifier cells are arranged in a two-dimensional matrix including multiple rows and multiple columns on a substrate.

Example 30 may include the subject matter of example 29, and may further include enabling amplifier cells in first rows of the multiple rows while at least one second row of the multiple rows includes a plurality of inactive cells including the at least one inactive amplifier cell, wherein the at least one second row is disposed between adjacent rows of the first rows.

Example 31 may include the subject matter of example 29 or example 30, and may further include enabling amplifier cells in first columns of the multiple columns while at least one second column of the multiple columns includes a plurality of inactive cells including the at least one inactive amplifier cell, wherein the at least one second column is disposed between adjacent columns of the first columns.

Example 32 may include the subject matter of any one of examples 29 to 31, wherein the activation sequence is to uniformly distribute the enabled amplifier cells among the plurality of amplifier cells, wherein the enabled amplifier cells are positioned at regular intervals with a number of inactive amplifier cells interposed between adjacent enabled amplifier cells along at least one dimension of the matrix.

Example 33 may include the subject matter of any one of examples 22 to 32, wherein the activation sequence is representative of a mapping of the amplitude control information to a binary pattern representing enabled and inactive states for the amplifier cells.

Example 34 may include the subject matter of any one of examples 22 to 33, and may further include determining which amplifier cells are to be enabled for generating the output signal based on a selected activation sequence.

Example 35 may include the subject matter of example 34, and may further include generating switching signals to selectively switch each amplifier cell into an enabled state when the selected activation sequence indicates an activation, and into an inactive state when the selected activation sequence indicates deactivation.

Example 36 may include the subject matter of any one of examples 22 to 35, wherein the amplitude control information is indicative of a desired output power level.

Example 37 may include the subject matter of any one of examples 22 to 36, wherein the enabled amplifier cells contribute to the output signal, and the at least one inactive amplifier cell is excluded from a contribution to the output signal.

Example 38 may include the subject matter of any one of examples 22 to 37, wherein the DPA includes a plurality of cell arrays including the plurality of amplifier cells.

Example 39 may include the subject matter of any one of examples 22 to 38, and may further include enabling a number of amplifier cells of the plurality of amplifier cells, wherein the number is based on the amplitude control information.

Example 40 may include the subject matter of example 39, wherein an amplitude of the output signal is proportional to the number of the enabled amplifier cells.

Example 41 may include the subject matter of a non-transitory computer-readable medium storing instructions that, when executed by a processor, cause the processor to: control a digital power amplifier (DPA) including a plurality of amplifier cells, wherein each amplifier cell is switchable to contribute to an output signal; and enable a subset of the plurality of amplifier cells according to an activation sequence, wherein the subset includes enabled amplifier cells arranged non-adjacently, with at least one inactive amplifier cell of the plurality of amplifier cells positioned between adjacent enabled amplifier cells.

Example 42 may include the subject matter of example 41, wherein the instructions further cause the processor to enable the subset of the plurality of amplifier cells based on a plurality of activation sequences including the activation sequence, each representing a distinct pattern to selectively enable the amplifier cells.

Example 43 may include the subject matter of example 42, wherein the instructions further cause the processor to select the activation sequence of the plurality of activation sequences based on a predetermined operating condition.

Example 44 may include the subject matter of example 42 or example 43, wherein the instructions further cause the processor to select the activation sequence of the plurality of activation sequences based on a thermal feedback received from a temperature sensor.

Example 45 may include the subject matter of any one of examples 42 to 44, wherein the instructions further cause the processor to select the activation sequence based on the amplitude control information.

Example 46 may include the subject matter of any one of examples 42 to 45, wherein the instructions further cause the processor to adaptively switch from a first activation sequence of the plurality of activation sequences to a second activation sequence of the plurality of activation sequences.

Example 47 may include the subject matter of any one of examples 42 to 46, wherein the instructions further cause the processor to alternate between the activation sequences in cycles to vary which amplifier cells are enabled.

Example 48 may include the subject matter of any one of examples 41 to 47, wherein the amplifier cells are arranged in a two-dimensional matrix including multiple rows and multiple columns on a substrate.

Example 49 may include the subject matter of example 48, wherein the instructions further cause the processor to enable amplifier cells in first rows of the multiple rows while at least one second row of the multiple rows includes a plurality of inactive cells including the at least one inactive amplifier cell, wherein the at least one second row is disposed between adjacent rows of the first rows.

Example 50 may include the subject matter of example 48 or example 49, wherein the instructions further cause the processor to enable amplifier cells in first columns of the multiple columns while at least one second column of the multiple columns includes a plurality of inactive cells including the at least one inactive amplifier cell, wherein the at least one second column is disposed between adjacent columns of the first columns.

Example 51 may include the subject matter of any one of examples 48 to 50, wherein the activation sequence is configured to uniformly distribute the enabled amplifier cells among the plurality of amplifier cells, wherein the enabled amplifier cells are positioned at regular intervals with a number of inactive amplifier cells interposed between adjacent enabled amplifier cells along at least one dimension of the matrix.

Example 52 may include the subject matter of any one of examples 41 to 51, wherein the activation sequence is representative of a mapping of the amplitude control information to a binary pattern representing enabled and inactive states for the amplifier cells.

Example 53 may include the subject matter of any one of examples 41 to 52, wherein the instructions further cause the processor to determine which amplifier cells are to be enabled for generating the output signal based on a selected activation sequence.

Example 54 may include the subject matter of example 53, wherein the instructions further cause the processor to generate switching signals to selectively switch each amplifier cell into an enabled state when the selected activation sequence indicates an activation, and into an inactive state when the selected activation sequence indicates deactivation.

Example 55 may include the subject matter of any one of examples 41 to 54, wherein the amplitude control information is indicative of a desired output power level.

Example 56 may include the subject matter of any one of examples 41 to 55, wherein the enabled amplifier cells contribute to the output signal, and the at least one inactive amplifier cell is excluded from a contribution to the output signal.

Example 57 may include the subject matter of any one of examples 41 to 56, wherein the DPA includes a plurality of cell arrays including the plurality of amplifier cells.

Example 58 may include the subject matter of any one of examples 41 to 57, wherein the instructions further cause the processor to enable a number of amplifier cells of the plurality of amplifier cells, wherein the number is based on the amplitude control information.

Example 59 may include the subject matter of example 58, wherein an amplitude of the output signal is proportional to the number of the enabled amplifier cells.

The word "exemplary" is used herein to mean "serving as an example, instance, or illustration". Any embodiment or design described herein as "exemplary" is not necessarily to be construed as preferred or advantageous over other embodiments or designs.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in plural form that does not expressly state "plurality" or "multiple" likewise refers to a quantity equal to or greater than one.

Any vector and/or matrix notation utilized herein is exemplary in nature and is employed solely for purposes of explanation. Accordingly, the apparatuses and methods described herein accompanied by vector and/or matrix notation are not limited to being implemented solely using vectors and/or matrices, and that the associated processes and computations may be equivalently performed with respect to sets, sequences, groups, etc., of data, observations, information, signals, samples, symbols, elements, etc.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

The term "software" refers to any type of executable instruction, including firmware.

In the context described herein, the term "process" may be used, for example, to indicate a method. Illustratively, any process described herein may be implemented as a method (e.g., a channel estimation process may be understood as a channel estimation method). Any process described herein may be implemented as a non-transitory computer readable medium including instructions configured, when executed, to cause one or more processors to carry out the process (e.g., to carry out the method).

Throughout the drawings, it should be noted that like reference numbers are used to depict the same or similar elements, features, and structures, unless otherwise noted. It should be noted that certain components may be omitted for the sake of simplicity. It should be noted that nodes (dots) are provided to identify the circuit line intersections in the drawings including electronic circuit diagrams.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

As used herein, a signal or information that is "indicative of", "representative", "representing", or "indicating" a value or other information may be a digital or analog signal that encodes or otherwise, communicates the value or other information in a manner that can be decoded by and/or cause a responsive action in a component receiving the signal. The signal may be stored or buffered in computer-readable storage medium prior to its receipt by the receiving component and the receiving component may retrieve the signal from the storage medium. Further, a "value" that is "indicative of "or "representative" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

The terms "one or more processors" is intended to refer to a processor or a controller. The one or more processors may include one processor or a plurality of processors. The terms are simply used as an alternative to the "processor" or "controller".

The term "user device" is intended to refer to a device of a user (e.g. occupant) that may be configured to provide information related to the user. The user device may exemplarily include a mobile phone, a smart phone, a wearable device (e.g. smart watch, smart wristband), a computer, etc.

As utilized herein, terms "module", "component," "system," "circuit," "element," "slice," " circuit," and the like are intended to refer to a set of one or more electronic components, a computer-related entity, hardware, software (e.g., in execution), and/or firmware. For example, circuit or a similar term can be a processor, a process running on a processor, a controller, an object, an executable program, a storage device, and/or a computer with a processing device. By way of illustration, an application running on a server and the server can also be circuit. One or more circuits can reside within the same circuit, and circuit can be localized on one computer and/or distributed between two or more computers. A set of elements or a set of other circuits can be described herein, in which the term "set" can be interpreted as "one or more".

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art. The term "data item" may include data or a portion of data.

It will be understood that when an element is referred to as being "connected" or "coupled" to another element, it can be physically connected or coupled to the other element such that current and/or electromagnetic radiation (e.g., a signal) can flow along a conductive path formed by the elements. Inherently, such element is connectable or couplable to the another element. Intervening conductive, inductive, or capacitive elements may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "provided" to an element, the voltage, current, or signal may be conducted to the element by way of a physical connection or by way of capacitive, electro-magnetic, or inductive coupling that does not involve a physical connection.

Unless explicitly specified, the term "instance of time" refers to a time of a particular event or situation according to the context. The instance of time may refer to an instantaneous point in time, or to a period of time which the particular event or situation relates to.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

While the above descriptions and connected figures may depict electronic device components as separate elements, skilled persons will appreciate the various possibilities to combine or integrate discrete elements into a single element. Such may include combining two or more circuits to form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method. All acronyms defined in the above description additionally hold in all claims included herein.

## Claims

1. An apparatus comprising:
a digital power amplifier (DPA) comprising a plurality of amplifier cells configured to provide an output signal based on amplitude control information, wherein each amplifier cell is switchable to contribute to the output signal; and
a controller configured to enable a subset of the plurality of amplifier cells according to an activation sequence, wherein the subset includes enabled amplifier cells arranged non-adjacently, with at least one inactive amplifier cell of the plurality of amplifier cells positioned between adjacent enabled amplifier cells.

2. The apparatus of claim 1, wherein the controller is further configured to enable the subset of the plurality of amplifier cells based on a plurality of activation sequences comprising the activation sequence, the activation sequences representing distinct patterns to selectively enable the amplifier cells;
preferably wherein the controller is configured to select the activation sequence of the plurality of activation sequences based on a predetermined operating condition.

3. The apparatus of claim 2,
wherein the controller is configured to select the activation sequence of the plurality of activation sequences based on a thermal feedback received from a temperature sensor; or
wherein the controller is further configured to select the activation sequence based on the amplitude control information.

4. The apparatus of any one of claims 2 or 3, wherein the controller is further configured to adaptively switch from a first activation sequence of the plurality of activation sequences to a second activation sequence of the plurality of sequences.

5. The apparatus of any one of claims 2 to 4, wherein the controller is further configured to alternate between the activation sequences in cycles to vary which amplifier cells are enabled.

6. The apparatus of any one of claims 1 to 5, wherein the amplifier cells are arranged in a two-dimensional matrix comprising multiple rows and multiple columns on a substrate;
preferably wherein first rows of the multiple rows comprise the enabled amplifier cells and at least one second row of the multiple rows comprises a plurality of inactive cells comprising the at least one inactive amplifier cell, wherein the at least one second row is disposed between adjacent rows of the first rows.

7. The apparatus of claim 6, wherein first columns of the multiple columns comprise the enabled amplifier cells and at least one second column of the multiple columns comprise a plurality of inactive cells comprising the at least one inactive amplifier cell, wherein the at least one second column is disposed between adjacent columns of the first columns.

8. The apparatus of any one of claims 1 to 7, wherein the activation sequence is representative of a mapping of the amplitude control information to a binary pattern representing enabled and inactive states for the amplifier cells.

9. The apparatus of any one of claims 1 to 8, wherein the controller is configured to determine which amplifier cells are to be enabled for generating the output signal based on a selected activation sequence;
preferably wherein the controller is configured to generate switching signals to selectively switch each amplifier cell into an enabled state when the selected activation sequence indicates an activation, and into an inactive state when the selected activation sequence indicates deactivation.

10. The apparatus of any one of claims 1 to 9, wherein the enabled amplifier cells are configured to contribute to the output signal, and the at least one inactive amplifier cell is excluded from a contribution to the output signal.

11. The apparatus of any one of claims 1 to 10, wherein the DPA comprises a plurality of cell arrays comprising the plurality of amplifier cells.

12. The apparatus of any one of claims 1 to 11, wherein the enabled amplifier comprises a number of amplifier cells of the plurality of amplifier cells, wherein the number is based on the amplitude control information.

13. A communication circuit comprising:
an apparatus of any one of claims 1 to 12; and
a digital-to-time converter configured to provide a phase modulated signal to the apparatus.

14. A non-transitory computer-readable medium storing instructions which, when executed by a processor, cause the processor to:
control a digital power amplifier (DPA) comprising a plurality of amplifier cells, wherein at least some of the amplifier cells are switchable to contribute to an output signal; and
enable a subset of the plurality of amplifier cells according to an activation sequence, wherein the subset includes enabled amplifier cells arranged non-adjacently, with at least one inactive amplifier cell of the plurality of amplifier cells positioned between adjacent enabled amplifier cells.

15. The non-transitory computer-readable medium of claim 14, wherein the instructions further cause the processor to enable the subset of the plurality of amplifier cells based on a plurality of activation sequences comprising the activation sequence, the activation sequences representing distinct patterns to selectively enable the amplifier cells.
